# EUROPEAN PATENT APPLICATION

(11) **EP 3 998 632 A1**
(43) Date of publication of application: **18.05.2022**
(21) Application number: 20871224.0
(22) Date of filing: 10.09.2020
(51) Int. Cl.: H01L 27/146

(54) **IMAGE SENSOR, CAMERA ASSEMBLY, AND MOBILE TERMINAL**

(30) Priority: 30.09.2019 CN 201910941638
(71) Applicant: GUANGDONG OPPO MOBILE TELECOMMUNICATIONS CORP., LTD., Dongguan, Guangdong 523860 (CN)
(72) Inventor: TANG, Cheng, Dongguan, Guangdong 523860 (CN); ZHANG, Gong, Dongguan, Guangdong 523860 (CN); ZHANG, Haiyu, Dongguan, Guangdong 523860 (CN); YANG, Xin, Dongguan, Guangdong 523860 (CN); XU, Rui, Dongguan, Guangdong 523860 (CN); SUN, Jianbo, Dongguan, Guangdong 523860 (CN); LAN, He, Dongguan, Guangdong 523860 (CN); LI, Xiaotao, Dongguan, Guangdong 523860 (CN); WANG, Wentao, Dongguan, Guangdong 523860 (CN)
(74) Representative: Penza, Giancarlo
(86) International application number: PCT/CN2020/114483
(87) International publication number: WO 2021/063162

(57) **Abstract**

An image sensor (10), a camera assembly (40), and a mobile terminal (60). The image sensor (10) comprises multiple pixels, and each pixel comprises an isolation layer (1183), a light guide layer (1184), and a photoelectric conversion element (117). The light guide layer (1184) is formed within the isolation layer (1183), and the refractive index of the light guide layer (1184) is greater than the refractive index of the isolation layer (1183). The photoelectric conversion element (117) receives light that passes through the light guide layer (1184).

## Description

### CROSS-REFERENCE TO RELATED APPLICATION(S)

This application claims priority and rights of a Chinese patent application No. 201910941638.8 filed with China National Intellectual Property Administration on September 30, 2019. The entire contents of the aforementioned application are incorporated herein by reference.

### TECHNICAL FIELD

This disclosure relates to the field of imaging technologies, and particularly to an image sensor, a camera assembly and a mobile terminal.

### BACKGROUND

Mobile terminals such as mobile phones are generally equipped with cameras for shooting. And an image sensor is provided in the camera. For capturing color images, the image sensor generally includes multiple pixels arranged in a two-dimensional array.

### SUMMARY

In one aspect, embodiments of the present disclosure provide an image sensor. The image sensor includes a plurality of pixels, and each of the pixels includes an isolation layer, a light guide layer, and a photoelectric conversion element. The light guide layer is formed in the isolation layer. The refractive index of the light guide layer is greater than the refractive index of the isolation layer. The photoelectric conversion element receives light passing through the light guide layer.

In another aspect, the embodiments of the present disclosure further provide a camera assembly. The camera assembly includes a lens and an image sensor. The image sensor receives light passing through the lens to obtain an original image. The image sensor includes a plurality of pixels, and each of the pixels includes an isolation layer, a light guide layer, and a photoelectric conversion element. The light guide layer is formed in the isolation layer. The refractive index of the light guide layer is greater than the refractive index of the isolation layer. The photoelectric conversion element receives light passing through the light guide layer.

In yet another aspect, the embodiments of the present disclosure further provide a mobile terminal. The mobile terminal includes a housing and a camera assembly. The camera assembly is jointed with the housing. The camera assembly includes a lens and an image sensor. The image sensor receives light passing through the lens to obtain an original image. The image sensor includes a plurality of pixels, and each of the pixels includes an isolation layer, a light guide layer, and a photoelectric conversion element. The light guide layer is formed in the isolation layer. The refractive index of the light guide layer is greater than the refractive index of the isolation layer. The photoelectric conversion element receives light passing through the light guide layer.

Additional aspects and advantages of the embodiments of the present disclosure will be partly given in the following description, and will partly become obvious from the following description, or be understood through the practice of the present disclosure.

Additional aspects and advantages of the embodiments of the present disclosure will be partly given in the following description, and will partly become obvious from the following description, or be understood through the practice of the present disclosure.

### BRIEF DESCRIPTION OF THE DRAWINGS

The above-mentioned and/or additional aspects and advantages of the present disclosure will become obvious and easily understood from the description of the embodiments in conjunction with the following drawings, in which:
FIG. 1 is a schematic diagram of an image sensor in the embodiments of the present disclosure;
FIG. 2 is a schematic diagram of a pixel circuit in the embodiments of the present disclosure;
FIG. 3 is a schematic diagram illustrating exposure saturation time of different color channels;
FIG. 4A is a schematic partial cross-sectional view of a pixel array in the embodiments of the present disclosure;
FIG. 4B is a schematic diagram illustrating the arrangement of the photoelectric conversion elements (or optical filters) in the pixel array of FIG. 4A;
FIG. 5A is a schematic partial cross-sectional view of another pixel array in the embodiments of the present disclosure;
FIG. 5B is a schematic diagram illustrating the arrangement of the photoelectric conversion elements (or optical filters) in the pixel array of FIG. 5A;
FIG. 5C is a schematic diagram illustrating another arrangement of the photoelectric conversion elements (or optical filters) in the pixel array of FIG. 5A;
FIG. 6A is a schematic partial cross-sectional view of yet another pixel array in the embodiments of the present disclosure;
FIG. 6B is a schematic diagram illustrating the arrangement of the optical filters in the pixel array of FIG. 6A;
FIG. 6C is a schematic diagram illustrating the arrangement of the photoelectric conversion elements in the pixel array of FIG. 6A;
FIG. 7A is a schematic partial cross-sectional view of yet another pixel array in the embodiments of the present disclosure;
FIG. 7B is a schematic diagram illustrating the arrangement of the optical filters in the pixel array of FIG. 7A;
FIG. 7C is a schematic diagram illustrating the arrangement of the photoelectric conversion elements in the pixel array of FIG. 7A;
FIG. 8A is a schematic partial cross-sectional view of yet another pixel array in the embodiments of the present disclosure;
FIG. 8B is a schematic diagram illustrating the arrangement of the optical filters in the pixel array of FIG. 8A;
FIG. 8C is a schematic diagram illustrating the arrangement of the photoelectric conversion elements in the pixel array of FIG. 8A;
FIG. 9A is a schematic partial cross-sectional view of yet another pixel array in the embodiments of the present disclosure;
FIG. 9B is a schematic diagram illustrating the arrangement of the photoelectric conversion elements (or optical filters) in the pixel array of FIG. 9A;
FIG. 10A is a schematic partial cross-sectional view of yet another pixel array in the embodiments of the present disclosure;
FIG. 10B is a schematic diagram illustrating the arrangement of the photoelectric conversion elements (or optical filters) in the pixel array of FIG. 10A;
FIG. 10C is a schematic diagram illustrating another arrangement of the photoelectric conversion elements (or optical filters) in the pixel array of FIG. 10A;
FIG. 11A is a schematic partial cross-sectional view of yet another pixel array in the embodiments of the present disclosure;
FIG. 11B is a schematic diagram illustrating the arrangement of the optical filters in the pixel array of FIG. 11A;
FIG. 11C is a schematic diagram illustrating the arrangement of the photoelectric conversion elements in the pixel array of FIG. 11A;
FIG. 12A is a schematic partial cross-sectional view of yet another pixel array in the embodiments of the present disclosure;
FIG. 12B is a schematic diagram illustrating the arrangement of the optical filters in the pixel array of FIG. 12A;
FIG. 12C is a schematic diagram illustrating the arrangement of the photoelectric conversion elements in the pixel array of FIG. 12A;
FIG. 13A is a schematic partial cross-sectional view of yet another pixel array in the embodiments of the present disclosure;
FIG. 13B is a schematic diagram illustrating the arrangement of the optical filters in the pixel array of FIG. 13A;
FIG. 13C is a schematic diagram illustrating the arrangement of the photoelectric conversion elements in the pixel array of FIG. 13A;
FIG. 14 is a schematic partial cross-sectional view of yet another pixel array in the embodiments of the present disclosure;
FIG. 15 is a schematic partial cross-sectional view of still yet another pixel array in the embodiments of the present disclosure;
FIG. 16 is a schematic diagram illustrating the connection of the pixel array and exposure control lines in the embodiments of the present disclosure;
FIG. 17 is a schematic diagram illustrating the arrangement of the pixels of one minimum repeating unit in the embodiments of the present disclosure;
FIG. 18 is a schematic diagram illustrating the arrangement of the pixels of another minimum repeating unit in the embodiments of the present disclosure;
FIG. 19 is a schematic diagram illustrating the arrangement of the pixels of yet another minimum repeating unit in the embodiments of the present disclosure;
FIG. 20 is a schematic diagram illustrating the arrangement of the pixels of yet another minimum repeating unit in the embodiments of the present disclosure;
FIG. 21 is a schematic diagram illustrating the arrangement of the pixels of yet another minimum repeating unit in the embodiments of the present disclosure;
FIG. 22 is a schematic diagram illustrating the arrangement of the pixels of yet another minimum repeating unit in the embodiments of the present disclosure;
FIG. 23 is a schematic diagram illustrating the arrangement of the pixels of yet another minimum repeating unit in the embodiments of the present disclosure;
FIG. 24 is a schematic diagram illustrating the arrangement of the pixels of yet another minimum repeating unit in the embodiments of the present disclosure;
FIG. 25 is a schematic diagram illustrating the arrangement of the pixels of yet another minimum repeating unit in the embodiments of the present disclosure;
FIG. 26 is a schematic diagram illustrating the arrangement of the pixels of yet another minimum repeating unit in the embodiments of the present disclosure;
FIG. 27 is a schematic diagram illustrating the arrangement of the pixels of yet another minimum repeating unit in the embodiments of the present disclosure;
FIG. 28 is a schematic diagram illustrating the arrangement of the pixels of yet another minimum repeating unit in the embodiments of the present disclosure;
FIG. 29 is a schematic diagram illustrating the arrangement of the pixels of yet another minimum repeating unit in the embodiments of the present disclosure;
FIG. 30 is a schematic diagram illustrating the arrangement of the pixels of yet another minimum repeating unit in the embodiments of the present disclosure;
FIG. 31 is a schematic diagram illustrating the arrangement of the pixels of yet another minimum repeating unit in the embodiments of the present disclosure;
FIG. 32 is a schematic diagram illustrating the arrangement of the pixels of yet another minimum repeating unit in the embodiments of the present disclosure;
FIG. 33 is a schematic diagram of a camera assembly in the embodiments of the present disclosure;
FIG. 34 is a schematic flowchart of an image capturing method in some embodiments of the present disclosure;
FIG. 35 is a schematic diagram illustrating the principle of the image capturing method in the related art;
FIG. 36 is a schematic diagram illustrating the principle of the image capturing method in the embodiments of the present disclosure;
FIG. 37 is another schematic diagram illustrating the principle of the image capturing method in the embodiments of the present disclosure;
FIG. 38 to FIG. 41 are schematic flowcharts of the image capturing method in some embodiments of the present disclosure;
FIG. 42 is another schematic diagram illustrating the principle of the image capturing method in the embodiments of the present disclosure;
FIG. 43 is yet another schematic diagram illustrating the principle of the image capturing method in the embodiments of the present disclosure;
FIG. 44 is yet another schematic diagram illustrating the principle of the image capturing method in the embodiments of the present disclosure;
FIG. 45 is yet another schematic diagram illustrating the principle of the image capturing method in the embodiments of the present disclosure;
FIG. 46 is yet another schematic diagram illustrating the principle of the image capturing method in the embodiment of the present disclosure; and
FIG. 47 is a schematic diagram of a mobile terminal in the embodiments of the present disclosure.

### DETAILED DESCRIPTION OF PREFERRED EMBODIMENTS

The embodiments of the present disclosure will be described in detail below. Examples of the embodiments are shown in the accompanying drawings, in which the same or similar reference numerals indicate the same or similar elements or elements with the same or similar functions throughout. The following embodiments described with reference to the drawings are exemplary, only for the purpose of explaining the embodiments of the present disclosure, and should not be understood as limitations on the embodiments of the present disclosure.

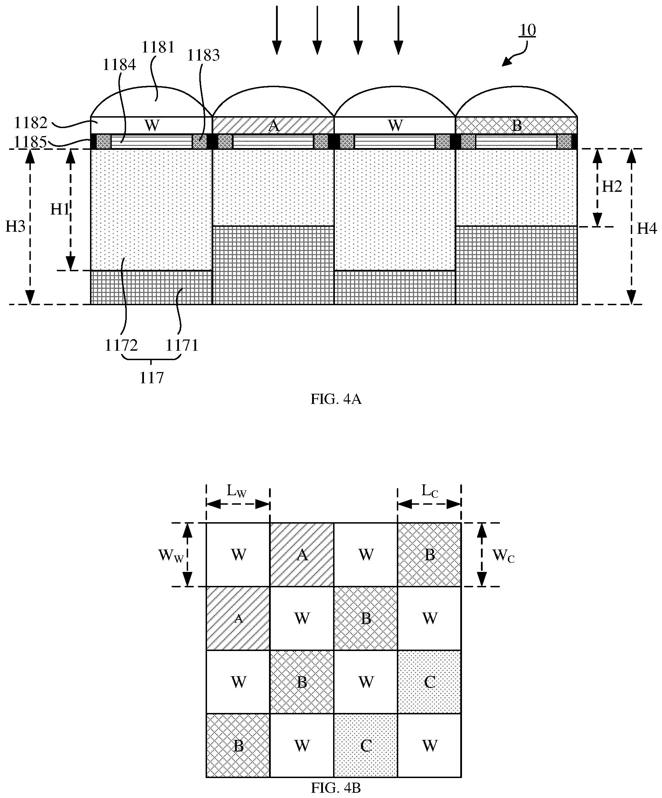

Referring to FIG. 4A, the embodiments of the disclosure provide an image sensor 10. The image sensor 10 includes multiple pixels. Each of the pixels includes an isolation layer 1183, a light guide layer 1184, and a photoelectric conversion element 117. The light guide layer 1184 is formed in the isolation layer 1183. The refractive index of the light guide layer 1184 is greater than the refractive index of the isolation layer 1183. The photoelectric conversion element 117 receives light passing through the light guide layer 1184.

Referring to FIG. 4A to FIG. 8C, in some embodiments, the refractive index of the light guide layer 1184 is constant; and in some embodiments, the refractive index of the light guide layer 1184 gradually increases.

Referring to FIG. 4A to FIG. 8C, in some embodiments, the image sensor 10 further includes an optical isolation interlayer 1185. The optical isolation interlayer 1185 is arranged between the isolation layers 1183 of two adjacent pixels.

In some embodiments, the multiple pixels include multiple panchromatic (full-color) pixels and multiple monochromatic (single-color) pixels. The monochromatic pixels have a narrower spectral response range than the panchromatic pixels, and each of the panchromatic pixels has a larger full well capacity than each of the monochromatic pixels.

Referring to FIG. 4A to FIG. 8C, in some embodiments, each of the pixels includes the photoelectric conversion element 117, and each photoelectric conversion element 117 includes a substrate 1171 and an n-well layer 1172 formed in the substrate 1171.

In some embodiments, a size of a cross section of the n-well layer 1172 of each of the panchromatic pixels is larger than a size of a cross section of the n-well layer 1172 of each of the monochromatic pixels, and a depth H1 of the n-well layer 1172 of each of the panchromatic pixels is greater than a depth H2 of the n-well layer 1172 of each of the monochromatic pixels.

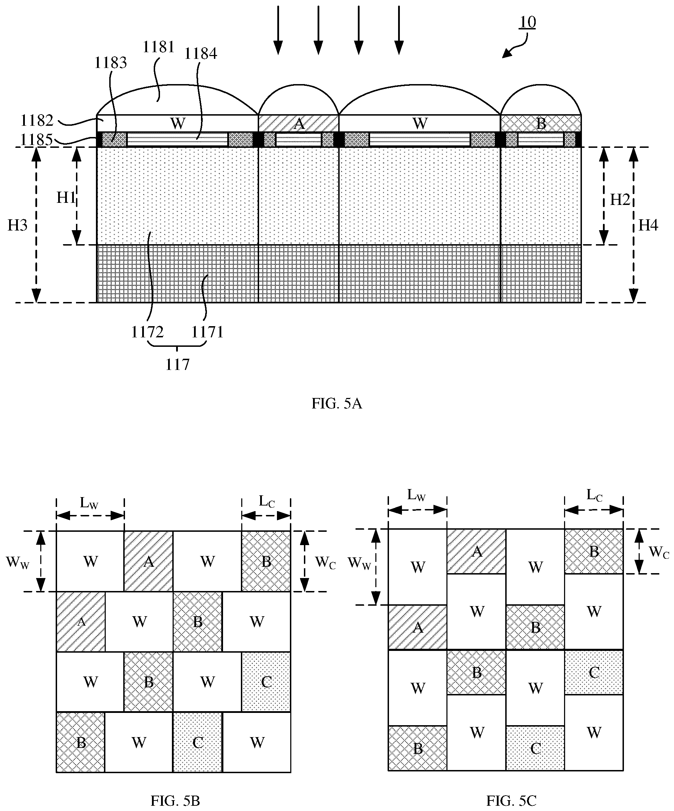

Referring to FIG. 5A to FIG. 5C, the size of the cross section of the n-well layer 1172 of each of the panchromatic pixels is larger than the size of the cross section of the n-well layer 1172 of each of the monochromatic pixels, and the depth H1 of the n-well layer 1172 of each of the panchromatic pixels is equal to the depth H2 of the n-well layer 1172 of each of the monochromatic pixels.

Referring to FIG. 4A to FIG. 5C, in some embodiments, along the light-receiving direction of the image sensor 10, the sizes of the individual cross sections of the n-well layer 1172 of each pixel are equal.

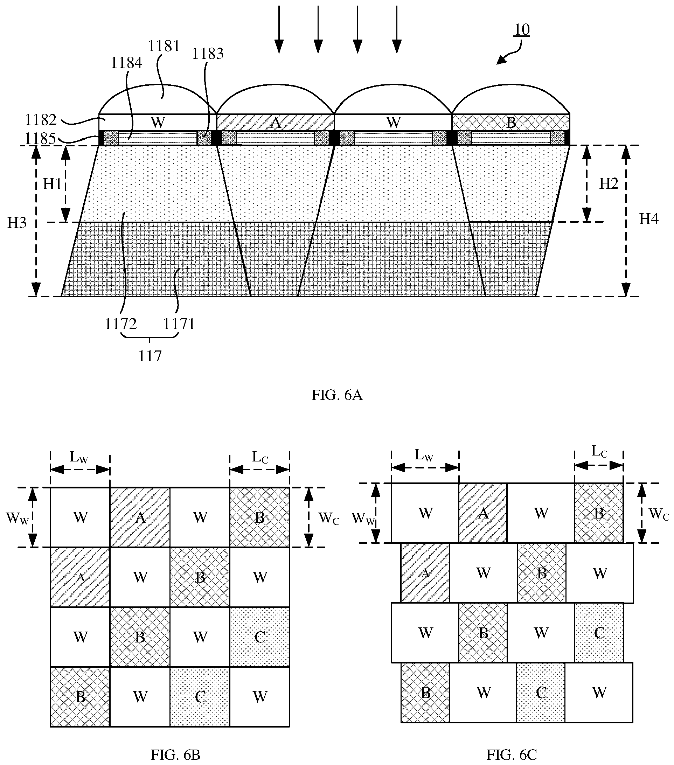

Referring to FIG. 6A to FIG. 7C, in some embodiments, the sizes of the individual cross sections of the n-well layer 1172 of each of the panchromatic pixels gradually increase along the light-receiving direction of the image sensor 10, the sizes of the individual cross sections of the n-well layer 1172 of each of the monochromatic pixels gradually decrease along the light-receiving direction, and the size of the smallest one of the cross sections of the n-well layer 1172 of each of the panchromatic pixels is greater than or equal to the size of the largest one of the cross sections of the n-well layer 1172 of each of the monochromatic pixels.

In the pixel array 11 provided in any of the embodiments shown in FIG. 4A to FIG. 8C, the depth H3 of the photoelectric conversion element 117 of each of the panchromatic pixels is equal to the depth H4 of the photoelectric conversion element 117 of each of the monochromatic pixels.

Referring to FIG. 4A to FIG. 8C, in some embodiments, each of the pixels includes a microlens 1181 and an optical filter 1182. Along the light-receiving direction of the image sensor 10, the microlens 1181, the optical filter 1182, the isolation layer 1183, and the photoelectric conversion element 117 are arranged in sequence.

Referring to FIG. 4A to FIG. 6C, in some embodiments, along the light-receiving direction of the image sensor 10, the sizes of the individual cross sections of the isolation layer 1183 of each pixel are equal.

In some embodiments, when the size of the cross section of the n-well layer 1172 of each of the panchromatic pixels is larger than the size of the cross section of the n-well layer 1172 of each of the monochromatic pixels, and when the sizes of the individual cross sections of the n-well layer 1172 of each pixel are equal along the light-receiving direction, the sizes of the individual cross sections of the isolation layer 1183 of each of the panchromatic pixels gradually increase along the light-receiving direction, and the sizes of the individual cross sections of the isolation layer 1183 of each of the monochromatic pixels gradually decrease along the light-receiving direction.

In some embodiments, when the sizes of the individual cross sections of the n-well layer 1172 of each of the panchromatic pixels gradually increase along the light-receiving direction of the image sensor 10, and when the sizes of the individual cross sections of the n-well layer 1172 of each of the monochromatic pixels gradually decrease along the light-receiving direction, the sizes of the individual cross sections of the isolation layer 1183 of each of the panchromatic pixels gradually increase along the light-receiving direction, and the sizes of the individual cross sections of the isolation layer 1183 of each of the monochromatic pixels gradually decrease along the light-receiving direction.

Referring to FIG. 4A to FIG. 6C, in some embodiments, the sizes of the individual cross sections of the light guide layer 1184 of each pixel are equal.

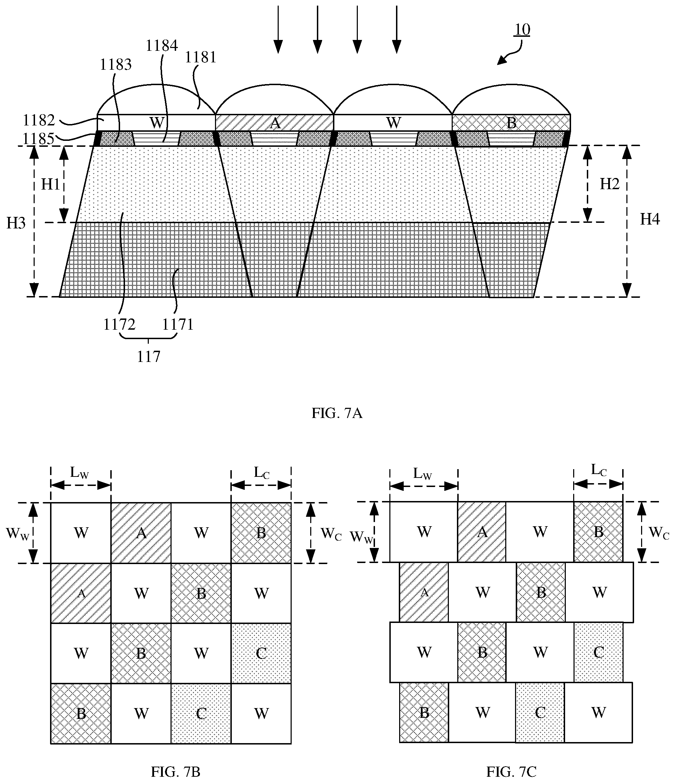

Referring to FIG. 7A to FIG. 8C, in some embodiments, the sizes of the individual cross sections of the light guide layer 1184 of each pixel gradually decrease along the light-receiving direction.

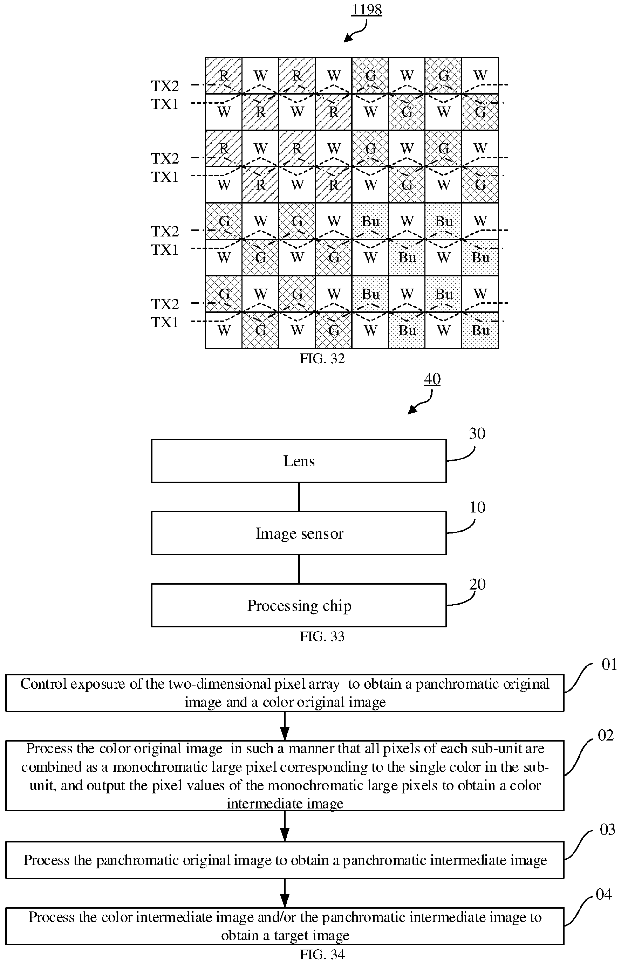

Referring to FIG. 33, the embodiments of the present disclosure further provide a camera assembly 40. The camera assembly 40 includes a lens 30 and an image sensor 10. The image sensor 10 receives light passing through the lens 30 to obtain an original image. The image sensor 10 includes multiple pixels, and each of the pixels includes an isolation layer 1183, a light guide layer 1184, and a photoelectric conversion element 117. The light guide layer 1184 is formed in the isolation layer 1183. The refractive index of the light guide layer 1184 is greater than the refractive index of the isolation layer 1183. The photoelectric conversion element 117 receives light passing through the light guide layer 1184.

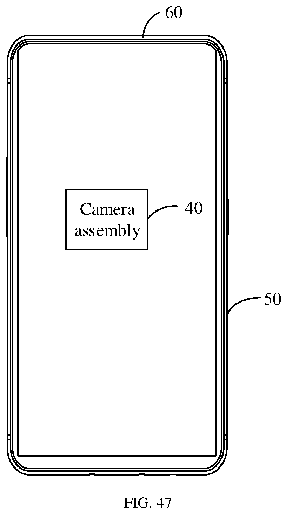

Referring to FIG. 47, the embodiments of the present disclosure further provide a mobile terminal 60. The mobile terminal 60 includes a housing 50 and a camera assembly 40. The camera assembly 40 is jointed with the housing 50. The camera assembly 40 includes a lens 30 and an image sensor 10. The image sensor 10 receives light passing through the lens 30 to obtain an original image. The image sensor 10 includes multiple pixels, and each of the pixels includes an isolation layer 1183, a light guide layer 1184, and a photoelectric conversion element 117. The light guide layer 1184 is formed in the isolation layer 1183. The refractive index of the light guide layer 1184 is greater than the refractive index of the isolation layer 1183. The photoelectric conversion element 117 receives light passing through the light guide layer 1184.

The embodiments of the present disclosure will be further described below in conjunction with the accompanying drawings.

In an image sensor including multiple pixels arranged in a two-dimensional pixel array, when non-perpendicularly irradiated light passes through the microlens and optical filter of a certain pixel, part of the light may be propagated to the photoelectric conversion elements of the adjacent pixels, which causes optical crosstalk. For an image sensor including pixels of multiple colors, optical crosstalk between adjacent pixels will cause a problem of color mixing, which in turn affects the imaging quality.

In view of the above, as shown in FIG. 4A, the embodiments of the present disclosure provide an image sensor 10. In this image sensor, by adding in each pixel an isolation layer 1183 and a light guide layer 1184 with a refractive index greater than that of the isolation layer 1183, the light passing through the microlens 1181 and the optical filter 1182 of each pixel is totally reflected in the structure composed of the isolation layer 1183 and the light guide layer 1184, thereby avoiding the optical crosstalk between adjacent pixels.

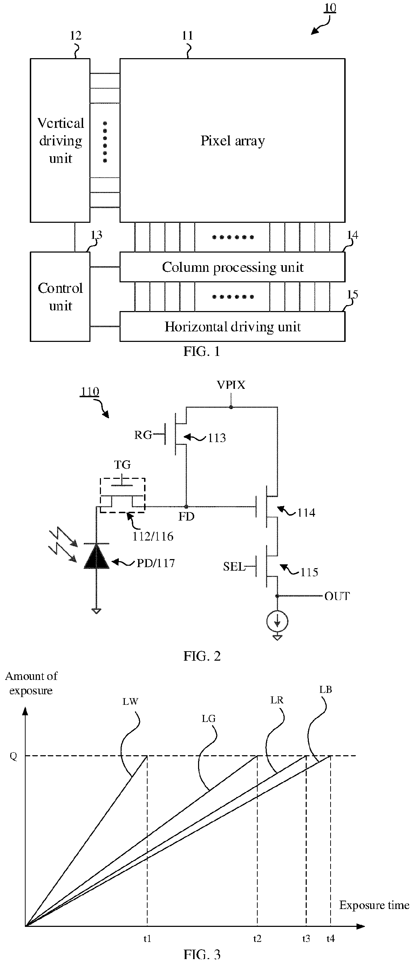

Next, the basic structure of the image sensor 10 will be introduced first. Referring to FIG. 1, a schematic diagram of the image sensor 10 in the embodiments of the present disclosure is illustrated. The image sensor 10 includes a pixel array 11, a vertical driving unit 12, a control unit 13, a column processing unit 14 and a horizontal driving unit 15.

For example, the image sensor 10 may adopt a Complementary Metal Oxide Semiconductor (CMOS) photosensitive element or a Charge-coupled Device (CCD) photosensitive element.

For example, the pixel array 11 includes multiple pixels (not shown in FIG. 1) arranged in a two-dimensional array, and each pixel includes a photoelectric conversion element 117 (shown in FIG. 2). Each pixel converts light into charges according to the intensity of the light incident on the pixel.

For example, the vertical driving unit 12 includes a shift register and an address decoder. The vertical driving unit 12 has a readout scanning function and a reset scanning function. The readout scanning means that the unit pixels are sequentially scanned line by line, to read signals from these unit pixels line by line. For example, the signal output by each pixel in the pixel row that is selected and scanned is transmitted to the column processing unit 14. The reset scanning is used to perform a reset operation in such a manner that the photo-charges of the photoelectric conversion element 117 are discarded, so that accumulation of new photo-charges can begin.

For example, the signal processing performed by the column processing unit 14 is correlated double sampling (CDS) processing. In the CDS processing, the reset levels and signal levels output from the individual pixels in the selected pixel row are extracted, and the level difference is calculated. Thus, the signals of the pixels in one row are obtained. The column processing unit 14 may have an analog-to-digital (A/D) conversion function for converting analog pixel signals into digital signals.

For example, the horizontal driving unit 15 includes a shift register and an address decoder. The horizontal driving unit 15 sequentially scans the pixel array 11 column by column. Through the selective scanning operation performed by the horizontal driving unit 15, the individual pixel columns are sequentially processed by the column processing unit 14, and the respective signals are sequentially output.

For example, the control unit 13 configures timing signals according to the operation mode, and utilizes various timing signals to control the vertical driving unit 13, the column processing unit 14 and the horizontal driving unit 15 to work together.

FIG. 2 is a schematic diagram of a pixel circuit 110 in the embodiments of the present disclosure. The pixel circuit 110 in FIG. 2 is applied to each pixel in FIG. 1. The working principle of the pixel circuit 110 will be described below in conjunction with FIG. 1 and FIG. 2.

As shown in FIG. 2, the pixel circuit 110 includes the photoelectric conversion element 117 (e.g., photodiode PD), an exposure control circuit 116 (e.g., transfer transistor 112), a reset circuit (e.g., reset transistor 113), an amplifier circuit (e.g., amplifier transistor 114) and a selection circuit (for example, selection transistor 115). In the embodiments of the present disclosure, the transfer transistor 112, the reset transistor 113, the amplifier transistor 114, and the selection transistor 115 are for example MOS transistors, but are not limited thereto.

For example, referring to FIG. 1 and FIG. 2, the gate TG of the transfer transistor 112 is connected to the vertical driving unit 12 through an exposure control line (not shown in the figure). The gate RG of the reset transistor 113 is connected to the vertical driving unit 12 through a reset control line (not shown in the figure). The gate SEL of the selection transistor 114 is connected to the vertical driving unit 12 through a selection line (not shown in the figure). In each pixel circuit 110, the exposure control circuit 116 (for example, the transfer transistor 112) is electrically connected to the photoelectric conversion element 117, for transferring the electric potential accumulated by the photoelectric conversion element 117 after being irradiated. For example, the photoelectric conversion element 117 includes a photodiode PD. The anode of the photodiode PD is connected to the ground, for example. The photodiode PD converts the received light into charges. The cathode of the photodiode PD is connected to a floating diffusion unit FD via the exposure control circuit 116 (for example, the transfer transistor 112). The floating diffusion unit FD is connected to the gate of the amplifier transistor 114 and the source of the reset transistor 113.

For example, the exposure control circuit 116 is the transfer transistor 112, and the control terminal TG of the exposure control circuit 116 is the gate of the transfer transistor 112. When a pulse of effective level (for example, VPIX level) is transmitted to the gate of the transfer transistor 112 through the exposure control line (not shown in the figure), the transfer transistor 112 is turned on. The transfer transistor 112 transfers the charges obtained by the photoelectric conversion of the photodiode PD to the floating diffusion unit FD.

For example, the drain of the reset transistor 113 is connected to a pixel power supply VPIX. The source of the reset transistor 113 is connected to the floating diffusion unit FD. Before the charges are transferred from the photodiode PD to the floating diffusion unit FD, a pulse of effective reset level is transmitted to the gate of the reset transistor 113 via the reset line, and the reset transistor 113 is turned on. The reset transistor 113 resets the floating diffusion unit FD to the level of the pixel power supply VPIX.

For example, the gate of the amplifier transistor 114 is connected to the floating diffusion unit FD. The drain of the amplifier transistor 114 is connected to the pixel power supply VPIX. After the floating diffusion unit FD is reset by the reset transistor 113, the amplifier transistor 114 outputs the reset level through the output terminal OUT via the selection transistor 115. After the charges of the photodiode PD are transferred by the transfer transistor 112, the amplifier transistor 114 outputs a signal level through the output terminal OUT via the selection transistor 115.

For example, the drain of the selection transistor 115 is connected to the source of the amplifier transistor 114. The source of the selection transistor 115 is connected to the column processing unit 14 in FIG. 1 through the output terminal OUT. When the pulse of effective level is transmitted to the gate of the selection transistor 115 through the selection line, the selection transistor 115 is turned on. The signal output by the amplifier transistor 114 is transmitted to the column processing unit 14 through the selection transistor 115.

It should be noted that the pixel structure of the pixel circuit 110 in the embodiments of the present disclosure is not limited to the structure shown in FIG. 3. For example, the pixel circuit 110 may have a pixel structure having three transistors, in which the functions of the amplifier transistor 114 and the selection transistor 115 are provided by one transistor. For example, the exposure control circuit 116 is not limited to the single transfer transistor 112, and other electronic devices or structures with a control terminal through which the conduction is controlled can be used as the exposure control circuit in the embodiments of the present disclosure. The implementation of the single transfer transistor 112 is simple, low cost, and easy to control.

The structure composed of the isolation layer 1183 and the light guide layer 1184 can be applied to an image sensor that only includes monochromatic pixels (including but not limited to RGB), or can also be applied to an image sensor that includes panchromatic pixels and monochromatic pixels, to enhance the imaging quality of the image sensor. However, besides the optical crosstalk that affects the imaging quality of the image sensor, the amount of exposure of the pixels also affects the imaging quality of the image sensor. For example, in an image sensor including panchromatic pixels and monochromatic pixels, pixels of different colors receive different amounts of exposure per unit time. In particular, after some pixels of a certain color are saturated, some pixels of other colors have not yet been exposed to an ideal state. For example, when the amount of exposure reaches 60%-90% of the saturation exposure, a relatively good signal-to-noise ratio and accuracy can be obtained, but the embodiments of the present disclosure are not limited thereto.

In FIG. 3, four pixels of RGBW (red, green, blue, and white) are taken as an example for illustration. See FIG. 3, the horizontal axis in FIG. 3 represents the exposure time, the vertical axis represents the amount of exposure, Q represents the saturation exposure, LW represents the exposure curve of the panchromatic pixel W, LG represents the exposure curve of the green pixel G, LR represents the exposure curve of the red pixel R, and LB represents the exposure curve of the blue pixel.

As can be seen from FIG. 3 that the slope of the exposure curve LW of the panchromatic pixel W is the largest, that is, the panchromatic pixel W obtains more exposure per unit time, and it reaches the saturation state at the time instant t1. The slope of the exposure curve LG of the green pixel G is the second largest, and the green pixel reaches the saturation state at the time instant t2. The slope of the exposure curve LR of the red pixel R is the third largest, and the red pixel reaches the saturation state at the time instant t3. The slope of the exposure curve LB of the blue pixel B is the smallest, and the blue pixel reaches the saturation state at the time instant t4. At the time instant t1, the panchromatic pixel W has been saturated, but the exposures of the three pixels of R, G, and B have not reached the ideal state.

In the related art, the exposure time of the four pixels of RGBW is commonly controlled. For example, the pixels in each row have the same exposure time, as they are connected to a same exposure control line and controlled by a same exposure control signal. For example, continue to refer to FIG. 3, during the period of time from 0 to t1, all four pixels of RGBW can work normally; but in this period of time, the three pixels of RGB have a short exposure time and a less amount of exposure, the image will be caused to have a low brightness and a low signal to noise ratio, and even the colors thereof are not bright enough. During the period of time from t1 to t4, the pixels W are overexposed due to saturation and thus cannot work normally, accordingly, the exposure data can no longer reflect the true object.

For enabling the image sensor 10 to provide better imaging quality, in addition to eliminating the optical crosstalk by adding the isolation layer 1183 and the light guide layer 1184, premature saturation of the panchromatic pixels can be prevented by increasing the full well capacity of the panchromatic pixel to such a degree that the full well capacity of each panchromatic pixel is larger than the full well capacity of each monochromatic pixel, thereby improving the imaging quality.

It should be noted that the exposure curves in FIG. 3 are only exemplary, and the slopes and relative relationships of the curves will vary depending on the response bands of the pixels, and the disclosure is not limited to the situation shown in FIG. 3. For example, when the red pixel R has a narrow spectral response range, the slope of the exposure curve of the red pixel R may be lower than the slope of the exposure curve of the blue pixel B.

FIG. 4A to FIG. 8C illustrates schematic diagrams of multiple cross sections of some pixels in the pixel array 11 of FIG. 1 which are taken along the light-receiving direction of the image sensor 10, and schematic diagrams of the arrangements of the photoelectric conversion elements 117 (or optical filters 1182) in the pixel array 11. Among them, the panchromatic pixels and the monochromatic pixels are arranged alternatively, and the monochromatic pixels have a narrower spectral response range than the panchromatic pixels. Each of the panchromatic pixels and the monochromatic pixels includes a microlens 1181, an optical filter 1182, an isolation layer 1183, a light guide layer 1184, and a photoelectric conversion element 117. Along the light-receiving direction of the image sensor 10, the microlens 1181, the optical filter 1182, the isolation layer 1183, and the photoelectric conversion element 117 are sequentially arranged. The photoelectric conversion element 117 includes a substrate 1171 and an n-well layer 1172 formed in the substrate 1171. The n-well layer 1172 enables the light to be converted into charges. The isolation layer 1183 is provided on one surface of the photoelectric conversion element 117 (specifically, one surface of the substrate 1171). Since the substrate 1171 is not completely flat, it is difficult for the optical filter 1182 to be directly provided on the surface of the substrate 1171. The isolation layer 1183 is provided on one surface of the substrate 1171, and the surface of the isolation layer 1183 away from the substrate 1171 has a relatively high flatness, which facilitates the placement of the optical filter 1182. The optical filter 1182 is disposed on the surface of the isolation layer 1183 away from the substrate 1171, and the optical filter 1182 allows light of a specific wave band to pass. The microlens 1181 is arranged on a side of the optical filter 1182 away from the isolation layer 1183. The microlens 1181 is configured to converge the light and guide more incident light to the photoelectric conversion element 117. The light guide layer 1184 is provided in the isolation layer 1183, and the refractive index of the light guide layer 1184 is greater than the refractive index of the isolation layer 1183. In each pixel, along a direction perpendicular to the light-receiving direction, the isolation layer 1183 of the pixel, the light guide layer 1184 of the pixel and the isolation layer 1183 of the pixel are sequentially arranged. For example, along the direction perpendicular to the light-receiving direction, the isolation layer 1183 of a panchromatic pixel W, the light guide layer 1184 of the panchromatic pixel W, and the isolation layer 1183 of the panchromatic pixel W are sequentially arranged, the isolation layer 1183 of a monochromatic pixel A, the light guide layer 1184 of the monochromatic pixel A, and the isolation layer 1183 of the monochromatic pixel A are sequentially arranged, the isolation layer 1183 of a monochromatic pixel B, the light guide layer 1184 of the monochromatic pixel B and the isolation layer 1183 of the monochromatic pixel B are sequentially arranged, and so on. This design can cause the light passing through the optical filter 1182 to be totally reflected in the structure composed of the isolation layer 1183 and the light guide layer 1184, thereby causing the light to be converged and allowing more light to enter the corresponding photoelectric conversion element 117, and avoiding the optical crosstalk between adjacent pixels. The full well capacity of the photoelectric conversion element 117 is related to the volume of the n-well layer 1172 of the photoelectric conversion element 117. The larger the volume of the n-well layer 1172, the greater the full well capacity. In any of the embodiments shown in FIG. 4A to FIG. 8C, the volume of the n-well layer 1172 of the panchromatic pixel is larger than the volume of the n-well layer 1172 of the monochromatic pixel, so that the full well capacity of the panchromatic pixel is greater than the full well capacity of the monochromatic pixel, thereby increasing the saturation exposure Q of the panchromatic pixel, and prolonging the period of time during which the panchromatic pixel reaches the saturation state. As such, the premature saturation of the panchromatic pixel is avoided, and the exposure of the panchromatic pixel and the exposure of the monochromatic pixel are balanced. In this way, the imaging quality of the image sensor 10 is improved, through the design of the isolation layer 1183 and the light guide layer 1184 and the design that the full well capacity of each panchromatic pixel is greater than the full well capacity of each monochromatic pixel.

For example, FIG. 4A is a schematic view of the cross section, taken along the light-receiving direction, of the pixel array 11 in an embodiment of the present disclosure, and FIG. 4B is a schematic view illustrating the arrangement of multiple photoelectric conversion elements 117 (or multiple optical filters 1182) of the pixel array 11. As shown in FIG. 4A, the sizes of the individual cross sections of the isolation layer 1183 of each pixel (the same pixel) are equal along the light-receiving direction. The sizes of the individual cross sections of the light guide layer 1184 of each pixel (the same pixel) are also equal along the light-receiving direction. The sizes of the individual cross sections of the n-well layer 1172 of each pixel (the same pixel) are also equal along the light-receiving direction. The size of the cross section of the n-well layer 1172 of the panchromatic pixel is equal to the size of the cross section of the n-well layer 1172 of the monochromatic pixel, and the depth H1 of the n-well layer 1172 of the panchromatic pixel is greater than the depth H2 of the n-well layer 1172 of the monochromatic pixel. In this way, the volume of the n-well layer 1172 of each panchromatic pixel is larger than the volume of the n-well layer 1172 of each monochromatic pixel, that is, each panchromatic pixel has a larger full well capacity than each monochromatic pixel. In addition, in the image sensor 10 shown in FIG. 4A, the light can be totally reflected in the structure composed of the isolation layer 1183 and the light guide layer 1184 to avoid the optical crosstalk.

In other embodiments, the structure of the light guide layer 1184 in FIG. 4A may also be configured in such a manner that the sizes of the cross sections of the light guide layer 1184 gradually decrease along the light-receiving direction.

It should be noted that, in the embodiments of the disclosure, the cross sections of the isolation layer 1183 are cross sections of the isolation layer 1183 taken along a direction perpendicular to the light-receiving direction, the cross sections of the light guide layer 1184 are cross sections of the light guide layer 1184 taken along the direction perpendicular to the light-receiving direction, and the cross sections of the n-well layer 1172 are cross sections of the n-well layer 1172 taken along the direction perpendicular to the light-receiving direction. The cross section of the isolation layer 1183 of each pixel corresponds to the shape and size of the cross section of the n-well layer 1172 of the pixel. The cross section can be a polygon, such as rectangle, square, parallelogram, rhombus, pentagon, and hexagon, which are not limited here.

The sizes of the individual cross sections of the n-well layer 1172 (or the isolation layer 1183 or the light guide layer 1184) of the same pixel being equal along the light-receiving direction, means that the individual cross sections have the same area, and the corresponding side lengths of the individual cross sections are all equal. The size of the cross section of the n-well layer 1172 of the panchromatic pixel being equal to the size of the cross section of the n-well layer 1172 of the monochromatic pixel, means that the area of the cross section of the n-well layer 1172 of the panchromatic pixel is equal to the area of the cross section of the n-well layer 1172 of the monochromatic pixel. The side lengths of the shape defined by the cross section of the n-well layer 1172 of the panchromatic pixel may be the same as or different from the corresponding side lengths of the shape defined by the cross section of the n-well layer 1172 of the monochromatic pixel. For example, as shown in FIG. 4B, the cross sections of the n-well layers 1172 of the panchromatic pixel and the monochromatic pixel are both rectangles, including a length and a width; the area of the cross section of the n-well layer 1172 of the panchromatic pixel is equal to the area of the cross section of the n-well layer 1172 of the monochromatic pixel; the length Lw of the cross section of the n-well layer 1172 of the panchromatic pixel is equal to the length Lc of the cross section of the n-well layer 1172 of the monochromatic pixel; and the width Ww of the cross section of the n-well layer 1172 of the panchromatic pixel is equal to the width Wc of the cross section of the n-well layer 1172 of the monochromatic pixel. In other examples, Lw may not be equal to Lc, and Ww may not be equal to Wc, as long as the area of the cross section of the n-well layer 1172 of the panchromatic pixel is equal to the area of the cross section of the n-well layer 1172 of the monochromatic pixel. In the following, the interpretations of the cross section of the n-well layer 1172 (or the isolation layer 1183 or the light guide layer 1184), the sizes of the individual cross sections of the n-well layer 1172 (or the isolation layer 1183 or the light guide layer 1184) of each pixel being equal, and the size of the cross section of the n-well layer 1172 of the panchromatic pixel being equal to the size of the cross section of the n-well layer 1172 of the monochromatic pixel are the same as those discussed here.

For example, FIG. 5A is a schematic diagram illustrating a cross section, taken along the light-receiving direction, of the pixel array 11 according to another embodiment of the present disclosure, and FIG. 5B and FIG. 5C are schematic diagrams illustrating two arrangements of multiple photoelectric conversion elements 117 (or multiple optical filters 1182) in the pixel array 11 of FIG. 5A. As shown in FIG. 5A, the sizes of the individual cross sections of the isolation layer 1183 of each pixel (the same pixel) are equal along the light-receiving direction. The sizes of the individual cross sections of the light guide layer 1184 of each pixel (the same pixel) are also equal along the light-receiving direction. The sizes of the individual cross sections of the n-well layer 1172 of each pixel (the same pixel) are also equal along the light-receiving direction. The size of the cross section of the n-well layer 1172 of the panchromatic pixel is larger than the size of the cross section of the n-well layer 1172 of the monochromatic pixel; and the depth H1 of the n-well layer 1172 of the panchromatic pixel is equal to the depth H2 of the n-well layer 1172 of the monochromatic pixel. In this way, the volume of the n-well layer 1172 of the panchromatic pixel is larger than the volume of the n-well layer 1172 of the monochromatic pixel, that is, the panchromatic pixel has a larger full well capacity than the monochromatic pixel. In addition, in the image sensor 10 shown in FIG. 5A, the light can be totally reflected in the structure composed of the isolation layer 1183 and the light guide layer 1184 to avoid the optical crosstalk.

Of course, in other embodiments, the depth H1 of the n-well layer 1172 of the panchromatic pixel may also be greater than the depth H2 of the n-well layer 1172 of the monochromatic pixel in FIG. 5A; and the structure of the light guide layer 1184 in FIG. 5A may also be configured in such a manner that the sizes of the cross sections of the light guide layer 1184 gradually decrease along the light-receiving direction.

It should be noted that the size of the cross section of the n-well layer 1172 of the panchromatic pixel being larger than the size of the cross section of the n-well layer 1172 of the monochromatic pixel, means that the area of the cross section of the n-well layer 1172 of the panchromatic pixel is larger than the area of the cross section of the n-well layer 1172 of the monochromatic pixel, and the side lengths of the shape defined by the cross section of the n-well layer 1172 of the panchromatic pixel may be partly or wholly greater than the corresponding side lengths of the shape defined by the cross section of the n-well layer 1172 of the monochromatic pixel. For example, as shown in FIG. 5B, the length Lw of the cross section of the n-well layer 1172 of the panchromatic pixel is larger than the length Lc of the cross section of the n-well layer 1172 of the monochromatic pixel, and the width Ww of the cross section of the n-well layer 1172 of the panchromatic pixel is equal to the width Wc of the cross section of the n-well layer 1172 of the monochromatic pixel. As shown in FIG. 5C, the length Lw of the cross section of the n-well layer 1172 of the panchromatic pixel is equal to the length Lc of the cross section of the n-well layer 1172 of the monochromatic pixel, and the width Ww of the cross section of the n-well layer 1172 of the panchromatic pixel is larger than the width Wc of the cross section of the n-well layer 1172 of the monochromatic pixel. In the following, the interpretations of the size of the cross section of the n-well layer 1172 of the panchromatic pixel being larger than the size of the cross section of the n-well layer 1172 of the monochromatic pixel is the same as those discussed here.

For example, FIG. 6A is a schematic diagram illustrating a cross section, taken along the light-receiving direction, of the pixel array 11 according to yet another embodiment of the present disclosure, FIG. 6B is a schematic diagram illustrating the arrangement of multiple optical filters 1182, and FIG. 6C is a schematic diagram illustrating the arrangement of multiple photoelectric conversion elements 117. As shown in FIG. 6A, the sizes of the individual cross sections of the isolation layer 1183 of each pixel (the same pixel) are equal along the light-receiving direction. The sizes of the individual cross sections of the light guide layer 1184 of each pixel (the same pixel) are also equal along the light-receiving direction. The sizes of the cross sections of the n-well layer 1172 of each panchromatic pixel (the same panchromatic pixel) gradually increase along the light-receiving direction, and the sizes of the cross sections of the n-well layer 1172 of each monochromatic pixel (the same monochromatic pixel) gradually decrease along the light-receiving direction, and the size of the smallest one of the cross sections of the n-well layer 1172 of the panchromatic pixel is equal to the size of the largest one of the cross sections of the n-well layer 1172 of the monochromatic pixel. The depth H1 of the n-well layer 1172 of the panchromatic pixel is equal to the depth H2 of the n-well layer 1172 of the monochromatic pixel. Although the size of the cross section of the optical filter 1182 of the panchromatic pixel is equal to the size of the cross section of the optical filter 1182 of the monochromatic pixel (the area and the corresponding side lengths are all the same), as shown in FIG. 6B, the sizes of the cross sections (other than the cross section having the smallest size) of the n-well layer 1172 in the photoelectric conversion element 117 of the panchromatic pixel are actually larger than the sizes of the cross sections of the n-well layer 1172 in the photoelectric conversion element 117 of the monochromatic pixel, as shown in FIG. 6C. In this way, the volume of the n-well layer 1172 of the panchromatic pixel is larger than the volume of the n-well layer 1172 of the monochromatic pixel, and the panchromatic pixel has a larger full well capacity than that of the monochromatic pixel. In addition, in the image sensor 10 shown in FIG. 6A, the light can be totally reflected in the structure composed of the isolation layer 1183 and the light guide layer 1184 to avoid the optical crosstalk.

In other embodiments, in FIG. 6A, the size of the smallest one of the cross sections of the n-well layer 1172 of the panchromatic pixel may also be larger than the size of the largest one of the cross sections of the n-well layer of the monochromatic pixel, the depth H1 of the n-well layer 1172 of the panchromatic pixel may also be greater than the depth H2 of the n-well layer 1172 of the monochromatic pixel, and the structure of the light guide layer 1184 can also be configured in such a manner that the sizes of the cross sections of the light guide layer 1184 gradually decrease along the light-receiving direction.

For example, FIG. 7A is a schematic diagram illustrating a cross section, taken along the light-receiving direction, of the pixel array 11 according to yet another embodiment of the present disclosure, FIG. 7B is a schematic diagram illustrating the arrangement of multiple optical filters 1182, and FIG. 7C is a schematic diagram illustrating the arrangement of multiple photoelectric conversion elements 117. As shown in FIG. 7A, the sizes of the individual cross sections of the isolation layer 1183 of each panchromatic pixel (the same panchromatic pixel) gradually increase along the light-receiving direction, and the sizes of the individual cross sections of the isolation layer 1183 of each monochromatic pixel (the same monochromatic pixel) gradually decrease along the light-receiving direction. The sizes of the cross sections of the light guide layer 1184 of each panchromatic pixel gradually decrease along the light-receiving direction, and the sizes of the cross sections of the light guide layer 1184 of each monochromatic pixel also gradually decrease along the light-receiving direction. The sizes of the cross sections of the n-well layer 1172 of each panchromatic pixel gradually increase along the light-receiving direction, and the sizes of the cross sections of the n-well layer 1172 of each monochromatic pixel gradually decrease along the light-receiving direction, and the size of the smallest one of the cross sections of the n-well layer 1172 of the panchromatic pixel is equal to the size of the largest one of the cross sections of the n-well layer 1172 of the monochromatic pixel. The depth H1 of the n-well layer 1172 of the panchromatic pixel is equal to the depth H2 of the n-well layer 1172 of the monochromatic pixel. Although the size of the cross section of the optical filter 1182 of the panchromatic pixel is equal to the size of the cross section of the optical filter 1182 of the monochromatic pixel (the area and the corresponding side lengths are all the same), as shown in FIG. 7B, the sizes of the cross sections (other than the cross section having the smallest size) of the n-well layer 1172 in the photoelectric conversion element 117 of the panchromatic pixel are actually larger than the sizes of the cross sections of the n-well layer 1172 in the photoelectric conversion element 117 of the monochromatic pixel, as shown in FIG. 7C. In this way, the volume of the n-well layer 1172 of the panchromatic pixel is larger than the volume of the n-well layer 1172 of the monochromatic pixel, and the panchromatic pixel has a larger full well capacity than the monochromatic pixel. In addition, in the image sensor 10 shown in FIG. 7A, the light can be totally reflected in the structure composed of the isolation layer 1183 and the light guide layer 1184 to avoid the optical crosstalk.

In other embodiments, in FIG. 7A, the size of the smallest one of the cross sections of the n-well layer 1172 of the panchromatic pixel may also be larger than the size of the largest one of the cross sections of the n-well layer of the monochromatic pixel, the depth H1 of the n-well layer 1172 of the panchromatic pixel can also be greater than the depth H2 of the n-well layer 1172 of the monochromatic pixel, and the structure of the light guide layer 1184 can also be configured in such a manner that the sizes of the individual cross sections of the light guide layer 1184 are equal along the light-receiving direction.

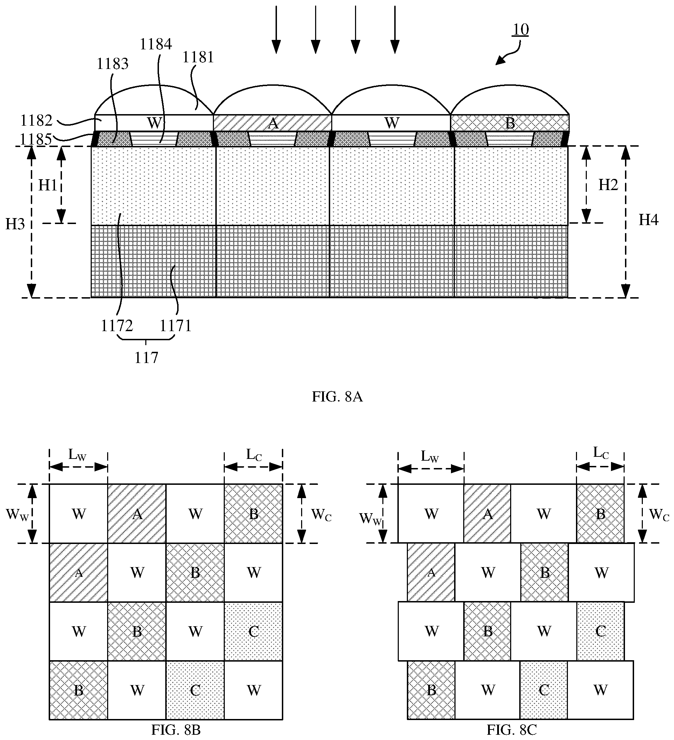

For example, FIG. 8A is a schematic diagram illustrating a cross section, taken along the light-receiving direction, of the pixel array 11 according to yet another embodiment of the present disclosure, FIG. 8B is a schematic diagram illustrating the arrangement of multiple optical filters 1182, and FIG. 8C is a schematic diagram illustrating the arrangement of multiple photoelectric conversion elements 117. As shown in FIG. 8A, the sizes of the individual cross sections of the isolation layer 1183 of each panchromatic pixel (the same panchromatic pixel) gradually increase along the light-receiving direction, the sizes of the individual cross sections of the isolation layer 1183 of each monochromatic pixel (the same monochromatic pixel) gradually decrease along the light-receiving direction, and the size of the smallest one of the cross sections of the isolation layer 1183 of the panchromatic pixel is equal to the size of the largest one of the cross sections of the isolation layer 1183 of the monochromatic pixel. The sizes of the cross sections of the light guide layer 1184 of each panchromatic pixel gradually decrease along the light-receiving direction, and the sizes of the cross sections of the light guide layer 1184 of each monochromatic pixel also gradually decrease along the light-receiving direction. The sizes of the individual cross sections of the n-well layer 1172 of each pixel are equal along the light-receiving direction. The size of the cross section of the n-well layer 1172 of the panchromatic pixel is larger than the size of the cross section of the n-well layer 1172 of the monochromatic pixel, and the depth H1 of the n-well layer 1172 of the panchromatic pixel is equal to the depth H2 of the n-well layer 1172 of the monochromatic pixel. Although the size of the cross section of the optical filter 1182 of the panchromatic pixel is equal to the size of the cross section of the optical filter 1182 of the monochromatic pixel (the area and the corresponding side lengths are all the same), as shown in FIG. 8B, the size of the cross section (other than the cross section having the smallest size) of the n-well layer 1172 in the photoelectric conversion element 117 of the panchromatic pixel is actually larger than the size of the cross section of the n-well layer 1172 in the photoelectric conversion element 117 of the monochromatic pixel, as shown in FIG. 8C. In this way, the volume of the n-well layer 1172 of the panchromatic pixel is larger than the volume of the n-well layer 1172 of the monochromatic pixel, and the panchromatic pixel has a larger full well capacity than the monochromatic pixel. In addition, in the image sensor 10 shown in FIG. 8A, the light can be totally reflected in the structure composed of the isolation layer 1183 and the light guide layer 1184 to avoid the optical crosstalk.

In other embodiments, the depth H1 of the n-well layer 1172 of the panchromatic pixel in FIG. 8A may also be greater than the depth H2 of the n-well layer 1172 of the monochromatic pixel, the size of the smallest one of the cross sections of the isolation layer 1183 of the panchromatic pixel in FIG. 8A may also be larger than the size of the largest one of the cross sections of the isolation layer 1183 of the monochromatic pixel, and the structure of the light guide layer 1184 in FIG. 8A can also be configured in such a manner that the sizes of the individual cross sections of the light guide layer 1184 of each pixel (the same pixel) are equal along the light-receiving direction.

In any of the embodiments shown in FIG. 4A to FIG. 8C, the refractive indexes at individual positions of the light guide layer 1184 may be equal, that is, the refractive index of the light guide layer 1184 is constant along the light-receiving direction. This can simplify the design of the light guide layer 1184 and reduce the manufacturing difficulty of the pixel array 11. In other embodiments, the refractive index of the light guide layer 1184 may also gradually increase along the light-receiving direction of the image sensor 10. This can enhance the light-converging ability of the light guide layer 1184, so that more light can enter the photoelectric conversion element 117.

In any of the embodiments shown in FIG. 4A to FIG. 8C, in the case where the sizes of the individual cross sections of the light guide layer 1184 of each pixel are equal along the light-receiving direction, the manufacturing process of the light guide layer 1184 can be simplified. In the case where the sizes of the cross sections of the light guide layer 1184 of each pixel gradually decrease along the light-receiving direction, the light-converging ability of the light guide layer 1184 can be enhanced, so that more light can enter the photoelectric conversion element 117.

In any of the embodiments shown in FIG. 4A to FIG. 8C, the depth of the light guide layer 1184 is equal to the depth of the isolation layer 1183, so that the light-converging ability of the light guide layer 1184 can be enhanced. In addition, compared with the thickness of the isolation layer in the existing image sensor, the thickness of the isolation layer 1183 of the present disclosure is larger, for example, larger than the thickness of the isolation layer in the existing image sensor by a predetermined thickness, so that a longer optical path can be defined, and the light-converging effect of the structure composed of the light guide layer 1184 and the isolation layer 1183 can thus be improved.

In the pixel array 11 provided by any one of the embodiments shown in FIG. 4A to FIG. 8C, the depth H3 of the photoelectric conversion element 117 of the panchromatic pixel is equal to the depth H4 of the photoelectric conversion element 117 of the monochromatic pixel. In particular, the depth H3 of the substrate 1171 of the panchromatic pixel is equal to the depth H4 of the substrate 1171 of the monochromatic pixel. When H3 and H4 are equal, the surface of the substrate 1171 of the panchromatic pixel that is away from the optical filter 1182 and the surface of the substrate 1171 of the monochromatic pixel that is away from the optical filter 1182 are in a same horizontal plane, which can reduce the complexity in designing and manufacturing the readout circuit.

Each pixel in any of the embodiments shown in FIG. 4A to FIG. 8C further includes the optical isolation interlayer 1185. The optical isolation interlayer 1185 is arranged between the isolation layers 1183 of two adjacent pixels. For example, one optical isolation interlayer 1185 is arranged between the isolation layer 1183 of the panchromatic pixel W and the isolation layer 1183 of the monochromatic pixel A, and another optical isolation interlayer 1185 is arranged between the isolation layer 1183 of the panchromatic pixel W and the isolation layer 1183 of the monochromatic pixel B. The optical isolation interlayer 1185 may be made of at least one material selected from tungsten, titanium, aluminum, and copper. The optical isolation interlayer 1185 can prevent the light incident on a pixel from entering another pixel adjacent to the pixel, and avoid causing noise to other pixels, that is, avoiding the optical crosstalk.

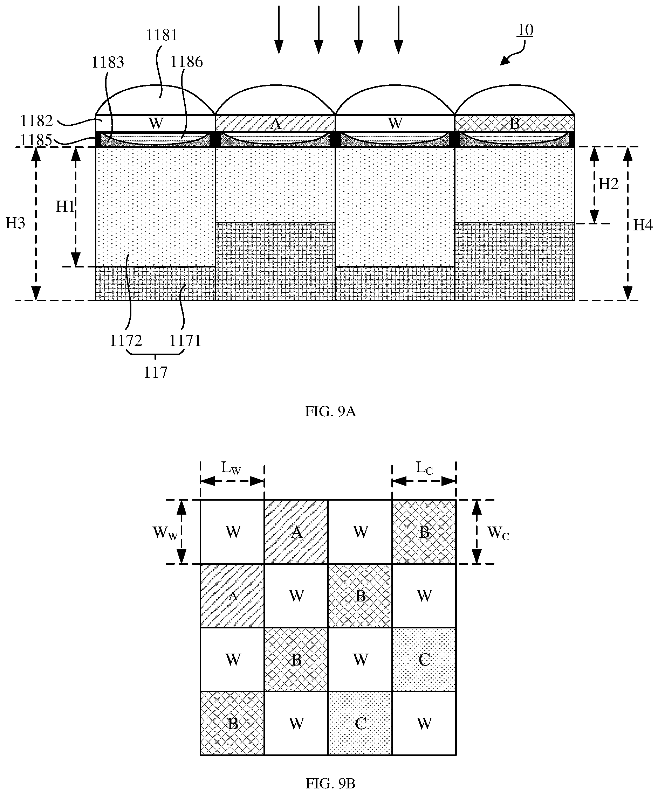

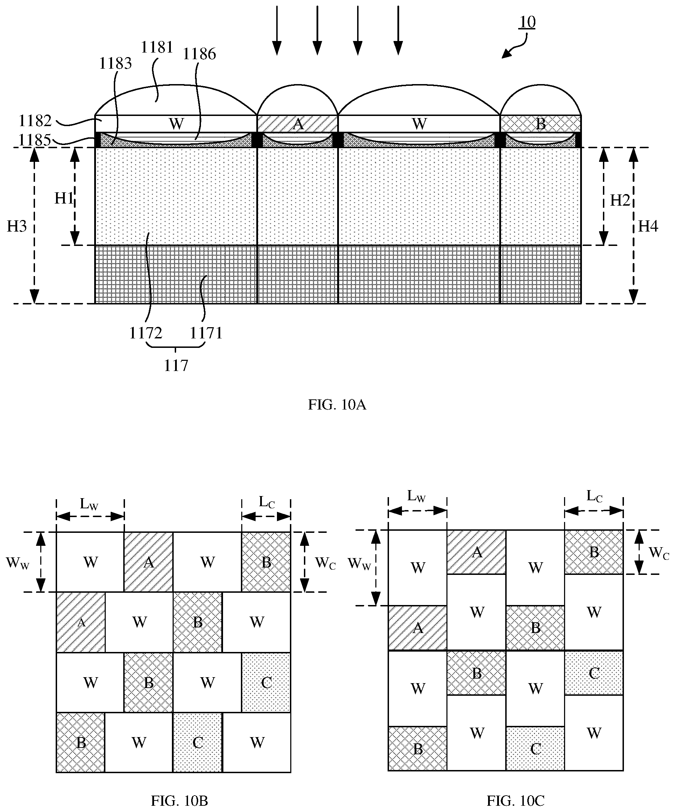

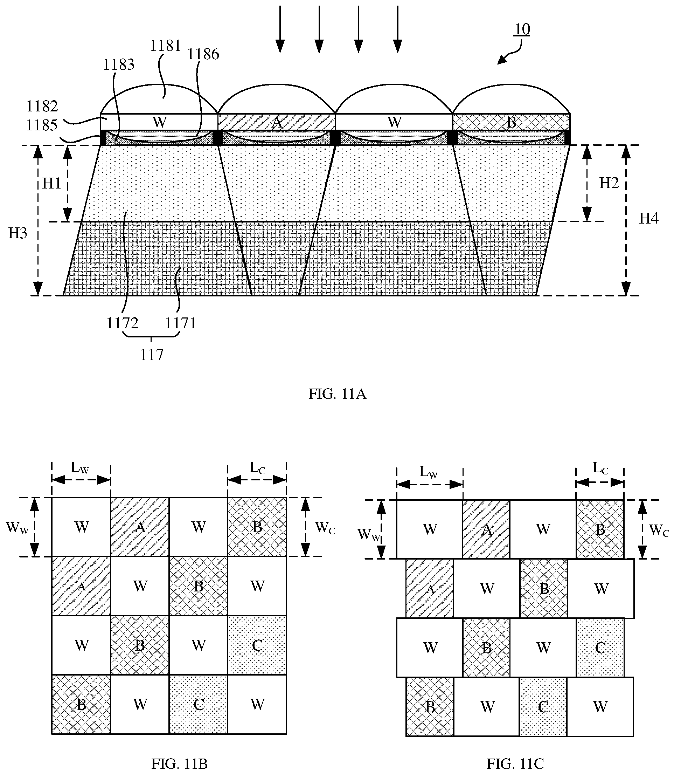

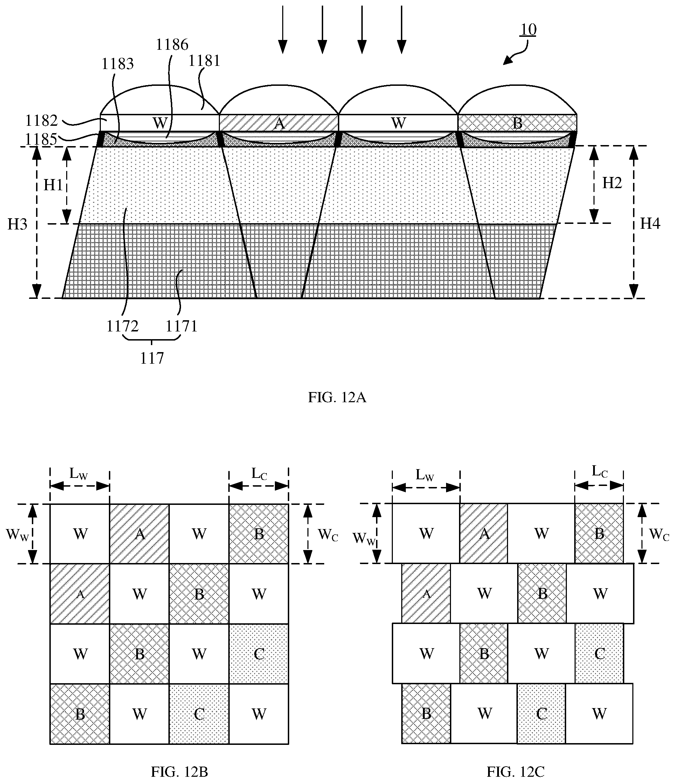

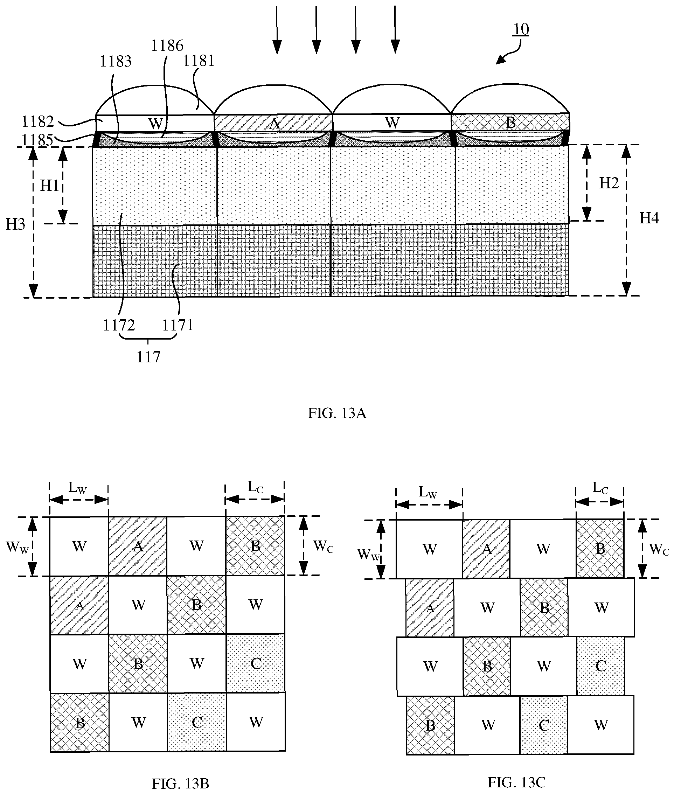

The light guide layer 1184 in each pixel in any of the embodiments shown in FIG. 4A to FIG. 8C can be replaced with a condenser lens 1186. Specifically, as shown in FIG. 9A to FIG. 13C, the structure of the image sensor 10 in FIG. 9A excepting the condenser lens 1186 is the same as that of the image sensor 10 in FIG. 4A, and the structure of the image sensor 10 in FIG. 10A excepting the condenser lens 1186 is the same as that of the image sensor 10 in FIG. 5A, the structure of the image sensor 10 in FIG. 11A excepting the condenser lens 1186 is the same as that of the image sensor in FIG. 6A, the structure of the image sensor 10 in FIG. 12A excepting the condenser lens 1186 is the same as that of the image sensor 10 in FIG. 7A, and the structure of the image sensor 10 in FIG. 13A excepting the condenser lens 1186 is the same as that of the image sensor 10 in FIG. 8A. The description of the microlens 1181, the optical filter 1182, the isolation layer 1183, the optical isolation interlayer 1185, and the photoelectric conversion element 117 (including the substrate 1171 and the n-well layer 1172) will not be repeated here.

As shown in FIG. 9A to FIG. 13C, each of the panchromatic pixels and the monochromatic pixels includes a condenser lens 1186, and the condenser lens 1186 is disposed in the isolation layer 1183 of the corresponding pixel. The condenser lens 1186 can play a role of converging light, so that more light passing through the optical filter 1182 can enter the photoelectric conversion element 117, thereby avoiding the optical crosstalk. In the case where each pixel is provided with the condenser lens 1186, the condenser lens 1186 of different curvature radii can be designed according to the requirements of different pixels. For example, the curvature radius of the condenser lens 1186 of the monochromatic pixel is larger than the curvature radius of the condenser lens 1186 of the panchromatic pixel, so that the light-converging ability of the condenser lens 1186 of the monochromatic pixel is higher than the light-converging ability of the condenser lens 1186 of the panchromatic pixel.

In other embodiments, only part of the pixels may include the condenser lens 1186. For example, the condenser lens 1186 may not be provided in the panchromatic pixels, and the condenser lens 1186 are only provided in the monochromatic pixels. For example, in the embodiments shown in FIG. 11A and FIG. 12A, the sizes of the cross sections of the n-well layer 1172 of the panchromatic pixel gradually increase along the light-receiving direction, and the sizes of the cross sections of the n-well layer of the monochromatic pixel gradually decrease along the light-receiving direction. Accordingly, most of the light passing through the optical filter 1182 of the panchromatic pixel can enter the photoelectric conversion element 117 of the panchromatic pixel, while a small part of the light passing through the optical filter 1182 of the monochromatic pixel can enter the photoelectric conversion element 117 of the monochromatic pixel. In this case, the condenser lens 1186 may be provided only in the isolation layers 1183 of the monochromatic pixels, so that the light-converging effect of the condenser lens 1186 allows more light to enter the photoelectric conversion element 117 of the monochromatic pixel. Provision of the condenser lens 1186 only in part of the pixels can reduce the manufacturing cost of the image sensor 10.

When the condenser lens 1186 is provided in the pixels, the side of each condenser lens 1186 facing the photoelectric conversion element 117 can be provided with an anti-reflection film. The anti-reflection film is configured to reduce light interference and thus avoid the light interference from influencing the imaging effect of the image sensor 10.

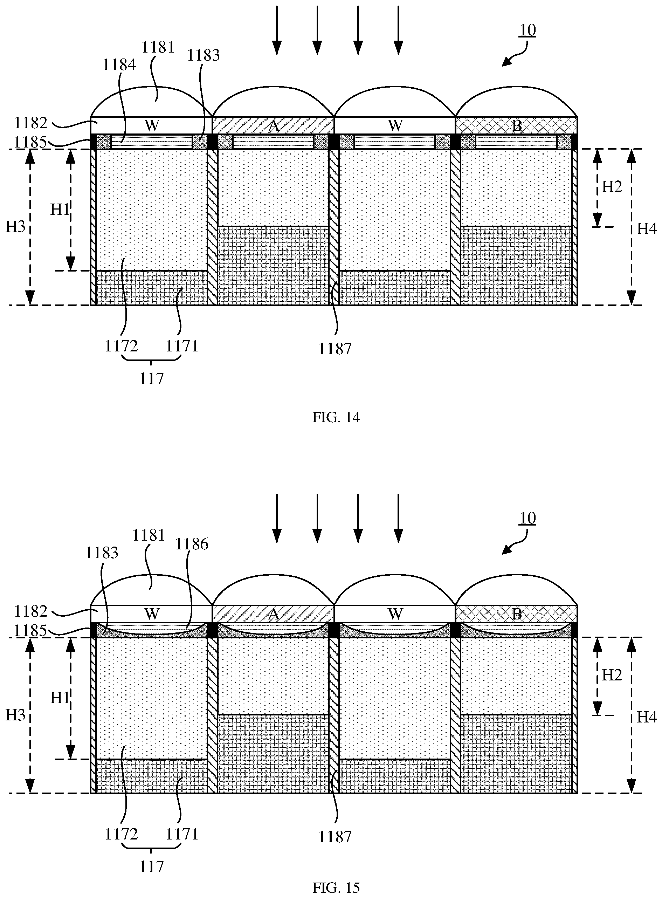

Referring to FIG. 14 and FIG. 15, the image sensor 10 further includes a barrier layer 1187. The barrier layer 1187 may be arranged between the photoelectric conversion elements 117 of two adjacent pixels. For example, one barrier layer 1187 is provided between the photoelectric conversion element 117 of the panchromatic pixel W and the photoelectric conversion element 117 of the monochromatic pixel A, and another barrier layer 1187 is provided between the photoelectric conversion element 117 of the panchromatic pixel W and the photoelectric conversion element 117 of the monochromatic pixel B, and so on. For example, the barrier layer 1187 may be deep trench isolation (DTI). The barrier layer 1187 can prevent the light entering the photoelectric conversion element 117 of a certain pixel from entering the photoelectric conversion elements 117 of other pixels adjacent to the pixel, and avoid causing noise to the photoelectric conversion elements 117 of other pixels, that is, avoiding the optical crosstalk.

In addition to setting the full well capacity of each panchromatic pixel to be greater than the full well capacity of each monochromatic pixel as described above, in the embodiments of the present disclosure, different full well capacities can also be set for the monochromatic pixels of different colors. Specifically, based on the sensitivities of the monochromatic pixels (the shorter the period of time required for reaching the saturation exposure of a pixel, the higher the sensitivity of the pixel), the full well capacities can be set correspondingly to the sensitivities of the monochromatic pixels. For example, as shown in FIG. 1, the sensitivity of the green pixel > the sensitivity of the red pixel > the sensitivity of the blue pixel, the full well capacities of the monochromatic pixels can be accordingly set as: the full well capacity of the green pixel > the full well capacity of the red pixel > the full well capacity of the blue pixel. Among them, the way of increasing the full well capacity of a monochromatic pixel is similar to the way of increasing the full well capacity of the panchromatic pixel. For example, when the area of the cross sections of the n-well layers 1172 of the individual pixels are equal, that is, S_{W}=S_{G}=S_{R}=S_{B}, the relationship among the depths of the n-well layers 1172 of the individual pixels can be H_{W}>H_{G}>H_{R}>H_{B}. For another example, when the depths of the n-well layers 1172 of the individual pixels are equal, that is, H_{W}=H_{G}=H_{R}=H_{B}, the relationship among the area of the cross sections of the n-well layers 1172 of the individual pixels may be S_{W}>S_{G}>S_{R}>S_{B}, and other situations will not be detailed here. In this way, different full well capacities can be set according to different sensitivities, so that the exposure of the pixels of various colors can be balanced, and the imaging quality can be improved.

On the basis of setting the full well capacity of each panchromatic pixel to be greater than the full well capacity of each monochromatic pixel, the exposure time of the panchromatic pixels and the exposure time of the monochromatic pixels can be further independently controlled to balance the exposure of the panchromatic pixels and the exposure of the monochromatic pixels.

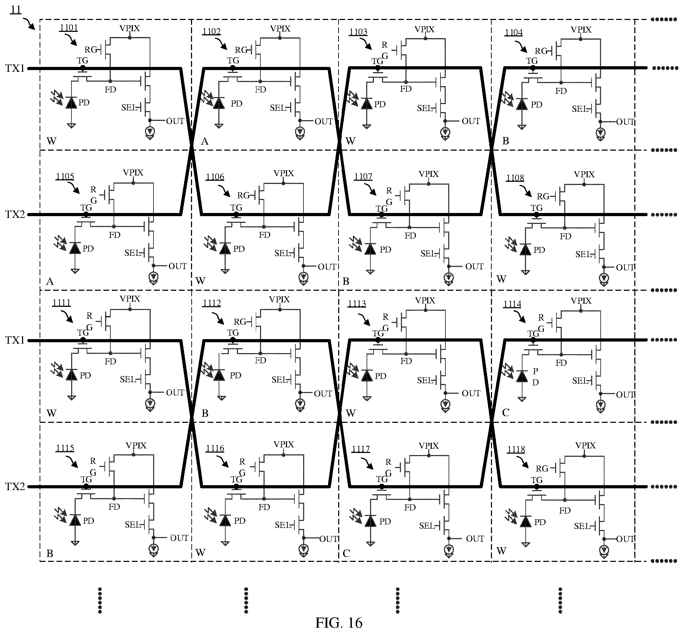

FIG. 16 is a schematic diagram illustrating the connection of the pixel array 11 and the exposure control lines according to the embodiments of the present disclosure. The pixel array 11 is a two-dimensional pixel array. The two-dimensional pixel array includes multiple panchromatic pixels and multiple monochromatic pixels, where the monochromatic pixels have a narrower spectral response range than the panchromatic pixels. The arrangement of the pixels in the pixel array 11 is as follows:

| | | | |
|---|---|---|---|
| W | A | W | B |
| A | W | B | W |
| W | B | W | C |
| B | W | C | W |

It should be noted that, for the convenience of illustration, only part of the pixels in the pixel array 11 are shown in FIG. 16, and other surrounding pixels and connection lines are indicated by ellipsis "...".

As shown in FIG. 16, pixels 1101, 1103, 1106, 1108, 1111, 1113, 1116, and 1118 are panchromatic pixels W, pixels 1102 and 1105 are first monochromatic pixels A (for example, red pixels R), pixels 1104, 1107, 1112 and 1115 are second monochromatic pixels B (for example, green pixels G), and pixels 1114 and 1117 are third monochromatic pixels C (for example, blue pixels Bu). It can be seen from FIG. 16 that the control terminals TG of the exposure control circuits in the panchromatic pixels W (pixels 1101, 1103, 1106, and 1108) are connected to one first exposure control line TX1, and the control terminals TG of the exposure control circuits in the panchromatic pixels W (pixels 1111, 1113, 1116, and 1118) are connected to another first exposure control line TX1. The control terminals TG of the exposure control circuits in the first monochromatic pixels A (pixels 1102 and 1105), and the control terminals TG of the exposure control circuits in the second monochromatic pixels B (pixels 1104 and 1107) are connected to one second exposure control line TX2, and the control terminals TG of the exposure control circuits in the second monochromatic pixels B (pixels 1112 and 1115), and the control terminals TG of the exposure control circuits in the third monochromatic pixels C (pixel 1114 and 1117) are connected to another second exposure control line TX2. Each first exposure control line TX1 can control the exposure time of the respective panchromatic pixels through a first exposure control signal. Each second exposure control line TX2 can control the exposure time of the respective monochromatic pixels (such as the first monochromatic pixels A and the second monochromatic pixels B, or the second monochromatic pixels B and the third monochromatic pixels C) through a second exposure control signal. In this way, the exposure time of the panchromatic pixels and the exposure time of the monochromatic pixels can be independently controlled. For example, the monochromatic pixels can continue to be exposed when the exposure of the panchromatic pixels ends, so as to achieve an ideal imaging effect.

Referring to FIG. 1 and FIG. 16, the first exposure control lines TX1 and the second exposure control lines TX2 are connected to the vertical driving unit 12 in FIG. 1, so that the corresponding exposure control signals in the vertical driving unit 12 are transmitted to the control terminals TG of the exposure control circuits in the pixels of the pixel array 11.

It can be understood that, as there are multiple groups of pixel rows in the pixel array 11, the vertical driving unit 12 is connected with multiple first exposure control lines TX1 and multiple second exposure control lines TX2. The multiple first exposure control lines TX1 and the multiple second exposure control lines TX2 correspond to corresponding groups of pixel rows.

For example, a first one of the first exposure control lines TX1 corresponds to the panchromatic pixels in the first and second rows; a second one of the first exposure control lines TX1 corresponds to the panchromatic pixels in the third and fourth rows, and so on. A third one of the first exposure control lines TX1 corresponds to the panchromatic pixels in the fifth and sixth rows, a fourth one of the first exposure control lines TX1 corresponds to the panchromatic pixels in the seventh and eighth rows, and the corresponding relationship between the first exposure control lines TX1 and the subsequent panchromatic pixels will not be repeated here. The timing of the signals transmitted by different first exposure control lines TX1 may also be different, and the timing of the signals is configured by the vertical driving unit 12.

For example, a first one of the second exposure control lines TX2 corresponds to the monochromatic pixels in the first and second rows; a second one of the second exposure control lines TX2 corresponds to the monochromatic pixels in the third and fourth rows, and so on. A third one of the second exposure control lines TX2 corresponds to the monochromatic pixels in the fifth and sixth rows, a fourth one of the second exposure control lines TX2 corresponds to the monochromatic pixels in the seventh and eighth rows, and the corresponding relationship between the second exposure control lines TX2 and the subsequent monochromatic pixels will not be repeated here. The timing of the signals transmitted by different second exposure control lines TX2 may also be different, and the timing of the signals is also configured by the vertical driving unit 12.

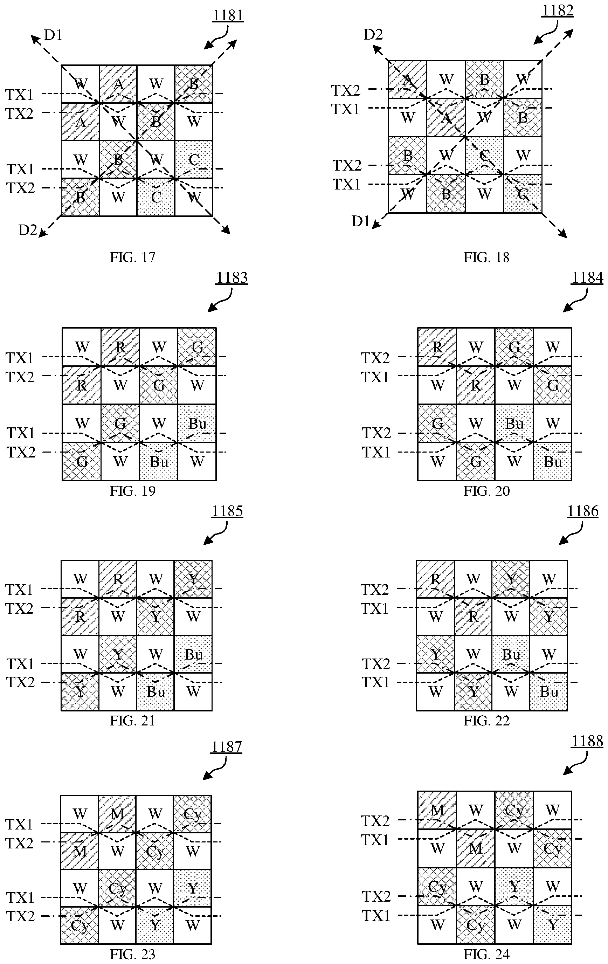

FIG. 17 to FIG. 32 show examples of multiple arrangements of the pixels of the image sensors 10 (shown in FIG. 1). Referring to FIG. 1 and FIG. 17 to FIG. 32, the image sensor 10 includes a two-dimensional pixel array (that is, the pixel array 11 shown in FIG. 16) composed of multiple monochromatic pixels (for example, multiple first monochromatic pixels A, multiple second monochromatic pixels B, and multiple third monochromatic pixels C) and multiple panchromatic pixels W. The monochromatic pixels have a narrower spectral response range than the panchromatic pixels. The response spectrum of the monochromatic pixels is, for example, a part of the response spectrum of the panchromatic pixels W. The two-dimensional pixel array includes minimum repeating units (FIG. 17 to FIG. 32 show multiple examples of the minimum repeating unit of the pixels in the image sensor 10), and the two-dimensional pixel array is composed of multiple minimum repeating units, in which the minimum repeating units are repeated and arranged in rows and columns. In the minimum repeating unit, the panchromatic pixels W are arranged in a first diagonal direction D1, the monochromatic pixels are arranged in a second diagonal direction D2, and the first diagonal direction D1 is different from the second diagonal direction D2. The first exposure time of at least two adjacent panchromatic pixels in the first diagonal direction D1 is controlled by a first exposure signal, and the second exposure time of at least two adjacent monochromatic pixels in the second diagonal direction D2 is controlled by a second exposure signal, so as to independently control the exposure time of the panchromatic pixels and the exposure time of the monochromatic pixels. Each minimum repeating unit includes multiple sub-units, and each sub-unit includes multiple monochromatic pixels (for example, multiple first monochromatic pixels A, multiple second monochromatic pixels B, or multiple third monochromatic pixels C) and multiple panchromatic pixels W. For example, referring to FIG. 2 and FIG. 16, the pixels 1101 to 1108 and the pixels 1111 to 1118 form a minimum repeating unit, where the pixels 1101, 1103, 1106, 1108, 1111, 1113, 1116, and 1118 are panchromatic pixels, and the pixels 1102, 1104, 1105, 1107, 1112, 1114, 1115, and 1117 are monochromatic pixels. The pixels 1101, 1102, 1105, and 1106 form a sub-unit, in which the pixels 1101 and 1106 are panchromatic pixels, and the pixels 1102 and 1105 are monochromatic pixels (for example, the first monochromatic pixels A). The pixels 1103, 1104, 1107, and 1108 form a sub-unit, in which the pixels 1103 and 1108 are panchromatic pixels, and the pixels 1104 and 1107 are monochromatic pixels (for example, the second monochromatic pixels B). The pixels 1111, 1112, 1115, and 1116 form a sub-unit, in which the pixels 1111 and 1116 are panchromatic pixels, and the pixels 1112 and 1115 are monochromatic pixels (for example, the second monochromatic pixels B). The pixels 1113, 1114, 1117, and 1118 form a sub-unit, in which the pixels 1113 and 1118 are panchromatic pixels, and the pixels 1114 and 1117 are monochromatic pixels (for example, the third monochromatic pixels C).

For example, in the minimum repeating unit, the number of pixels in the rows and the number of pixels in the columns are equal. For example, the minimum repeating unit includes, but is not limited to, a minimum repeating unit of 4 rows and 4 columns, 6 rows and 6 columns, 8 rows and 8 columns, and 10 rows and 10 columns. For example, in each sub-unit of the minimum repeating unit, the number of pixels in the rows and the number of pixels in the columns are equal. For example, the sub-unit includes, but is not limited to, a sub-unit of 2 rows and 2 columns, 3 rows and 3 columns, 4 rows and 4 columns, and 5 rows and 5 columns. Such setting is beneficial to balance the resolution and color performance of the image in the row and column directions, and improve the display effect.

For example, FIG. 17 is a schematic diagram illustrating the arrangement of the pixels of one minimum repeating unit 1181 in the embodiments of the present disclosure. The minimum repeating unit has 4 rows and 4 columns, i.e., 16 pixels in total, and each of the sub-units has 2 rows and 2 columns, i.e., 4 pixels in total. The arrangement is as follows:

| | | | |
|---|---|---|---|
| W | A | W | B |
| A | W | B | W |
| W | B | W | C |
| B | W | C | W |

W represents the panchromatic pixel, A represents the first monochromatic pixel of the multiple monochromatic pixels, B represents the second monochromatic pixel of the multiple monochromatic pixels, and C represents the third monochromatic pixel of the multiple monochromatic pixels.

For example, as shown in FIG. 17, the panchromatic pixels W are arranged in the first diagonal direction D1 (that is, a direction in a line connecting an upper left corner and a lower right corner in FIG. 17), and the monochromatic pixels are arranged in the second diagonal direction D2 (for example, a direction in a line connecting a lower left corner and an upper right corner in FIG. 17), the first diagonal direction D1 is different from the second diagonal direction D2. For example, the first diagonal and the second diagonal are perpendicular to each other. The first exposure time of two adjacent panchromatic pixels W in the first diagonal direction D1 (for example, two panchromatic pixels respectively located in the first row and first column and in the second row and second column counting from the upper left corner) is controlled by the first exposure signal, and the second exposure time of at least two adjacent monochromatic pixels in the second diagonal direction D2 (for example, two monochromatic pixels B respectively located in the fourth row and first column and in the third row and second column counting from the upper left corner) is controlled by the second exposure signal.

It should be noted that the first diagonal direction D1 and the second diagonal direction D2 are not limited to the diagonals, and can also include directions parallel to the diagonals. For example, in FIG. 16, the panchromatic pixels 1101, 1106, 1113 and 1118 are arranged in the first diagonal direction D1, the panchromatic pixels 1103 and 1108 are also arranged in the first diagonal direction D1, and the panchromatic pixels 1111 and 1116 are also arranged in the first diagonal direction D1. The monochromatic pixels 1104, 1107, 1112, and 1115 are arranged in the second diagonal direction D2, the first monochromatic pixels 1102 and 1105 are also arranged in the second diagonal direction D2, and the third monochromatic pixels 1114 and 1117 are also arranged in the second diagonal direction D2. The interpretations of the first diagonal direction D1 and the second diagonal direction D2 in FIG. 18 to FIG. 32 below are the same as those discussed here. The "direction" here is not unidirectional, and it can be understood as the concept of a "straight line" for indicating the arrangement, covering two directions at both ends of the straight line.

It should be understood that the orientation or positional relationship indicated by the terms such as "upper", "lower", "left", and "right" here and below is based on the orientation or positional relationship shown in the drawings, and is only for convenience and simplication of the description of this disclosure, instead of indicating or implying that the device or element of interest must have a specific orientation, or must be constructed and operated in a specific orientation, and therefore cannot be understood as limiting the disclosure.

For example, as shown in FIG. 17, the panchromatic pixels in the first row and the second row are connected together by the first exposure control line TX1 in a shape of "W", to realize the independent control of the exposure time of these panchromatic pixels. The monochromatic pixels (pixels A and B) in the first row and the second row are connected together by the second exposure control line TX2 in a shape of "W", to realize the independent control of the exposure time of these monochromatic pixels. The panchromatic pixels in the third row and the fourth row are connected together by the first exposure control line TX1 in the shape of "W", to realize the independent control of the exposure time of these panchromatic pixels. The monochromatic pixels (pixels B and C) in the third row and the fourth row are connected together by the second exposure control line TX2 in the shape of "W", to realize the independent control of the exposure time of these monochromatic pixels. For example, the first exposure signal is transmitted via the first exposure control line TX1, and the second exposure signal is transmitted via the second exposure control line TX2. For example, the first exposure control line TX1 is in the shape of "W" and is electrically connected to the control terminals of the exposure control circuits of the panchromatic pixels in two adjacent rows. The second exposure control line TX2 is in the shape of "W" and is electrically connected to the control terminals of the exposure control circuits of the monochromatic pixels in the two adjacent rows. For the specific connections, reference may be made to the description of the connection and the pixel circuit of FIG. 2 and FIG. 17.

It should be noted that, the first exposure control line TX1 being in the shape of "W" and the second exposure control line TX2 being in the shape of "W" do not mean that the physical wiring of these lines must define the shape of "W", as long as the connection thereof corresponds to the arrangement of the panchromatic pixels and the monochromatic pixels. For example, the exposure control lines are set to be in the shape of "W", so as to correspond to the "W"-type arrangement of the pixels. With such setting, the wiring is simple, and the arrangement of the pixels can provide good resolution and color effect, and the exposure time of the panchromatic pixels and the exposure time of the monochromatic pixels can be independently controlled at low cost.

For example, FIG. 18 is a schematic diagram illustrating the arrangement of the pixels of yet another minimum repeating unit 1182 in the embodiments of the present disclosure. The minimum repeating unit has 4 rows and 4 columns, i.e., 16 pixels in total, and each of the sub-units has 2 rows and 2 columns, i.e., 4 pixels in total. The arrangement is as follows:

| | | | |
|---|---|---|---|
| A | W | B | W |
| W | A | W | B |
| B | W | C | W |
| W | B | W | C |

W represents the panchromatic pixel, A represents the first monochromatic pixel of the multiple monochromatic pixels, B represents the second monochromatic pixel of the multiple monochromatic pixels, and C represents the third monochromatic pixel of the multiple monochromatic pixels.

For example, as shown in FIG. 18, the panchromatic pixels W are arranged in the first diagonal direction D1 (that is, a direction in a line connecting an upper right corner and a lower left corner in FIG. 18), and the monochromatic pixels are arranged in the second diagonal direction D2 (for example, a direction in a line connecting an upper left corner and a lower right corner in FIG. 18). For example, the first diagonal and the second diagonal are perpendicular to each other. The first exposure time of two adjacent panchromatic pixels W in the first diagonal direction D1 (for example, two panchromatic pixels respectively located in the first row and second column and in the second row and first column counting from the upper left corner) is controlled by the first exposure signal, and the second exposure time of at least two adjacent monochromatic pixels in the second diagonal direction D2 (for example, two monochromatic pixels A respectively located in the first row and first column and in the second row and second column counting from the upper left corner) is controlled by the second exposure signal.

For example, as shown in FIG. 18, the panchromatic pixels in the first row and the second row are connected together by the first exposure control line TX1 in the shape of "W", to realize the independent control of the exposure time of these panchromatic pixels. The monochromatic pixels (pixels A and B) in the first row and the second row are connected together by the second exposure control line TX2 in the shape of "W" to realize the independent control of the exposure time of these monochromatic pixels. The panchromatic pixels in the third row and the fourth row are connected together by the first exposure control line TX1 in the shape of "W" to realize the independent control of the exposure time of these panchromatic pixels. The monochromatic pixels (pixels B and C) in the third row and the fourth row are connected together by the second exposure control line TX2 in the shape of "W" to realize the independent control of the exposure time of these monochromatic pixels.

For example, FIG. 19 is a schematic diagram illustrating the arrangement of the pixels of yet another minimum repeating unit 1183 in the embodiments of the present disclosure. FIG. 20 is a schematic diagram illustrating the arrangement of the pixels of yet another minimum repeating unit 1184 in the embodiments of the present disclosure. In the embodiments of FIG. 19 and FIG. 20, they correspond to the arrangements of FIG. 17 and FIG. 18 respectively, in which the first monochromatic pixel A is the red pixel R, the second monochromatic pixel B is the green pixel G, and the third monochromatic pixel C is the blue pixel Bu.

It should be noted that, in some embodiments, the response band of the panchromatic pixel W is the visible light band (for example, 400 nm-760 nm). For example, the panchromatic pixel W is provided thereon with an infrared filter to filter out the infrared light. In some embodiments, the response band of the panchromatic pixel W is the visible light band plus the near-infrared band (for example, 400 nm-1000 nm), which matches the response band of the photoelectric conversion element 117 (for example, the photodiode PD) in the image sensor 10. For example, the panchromatic pixel W may not be provided with an optical filter, and the response band of the panchromatic pixel W is determined by the response band of the photodiode, that is, the two response bands match each other. The embodiments of the present disclosure include but are not limited to the above-mentioned wave bands.

For example, FIG. 21 is a schematic diagram illustrating the arrangement of the pixels of yet another minimum repeating unit 1185 in the embodiments of the present disclosure. FIG. 22 is a schematic diagram illustrating the arrangement of the pixels of yet another minimum repeating unit 1186 in the embodiments of the present disclosure. In the embodiments of FIG. 21 and FIG. 22, they correspond to the arrangements of FIG. 17 and FIG. 18 respectively, in which the first monochromatic pixel A is the red pixel R, the second monochromatic pixel B is a yellow pixel Y, and the third monochromatic pixel C is the blue pixel Bu.

For example, FIG. 23 is a schematic diagram illustrating the arrangement of the pixels of yet another minimum repeating unit 1187 in the embodiments of the present disclosure. FIG. 24 is a schematic diagram illustrating the arrangement of the pixels of yet another minimum repeating unit 1188 in the embodiments of the present disclosure. In the embodiments of FIG. 23 and FIG. 24, they correspond to the arrangements of FIG. 17 and FIG. 18 respectively, in which the first monochromatic pixel A is a magenta pixel M, the second monochromatic pixel B is a cyan pixel Cy, and the third monochromatic pixel C is the Yellow pixel Y.

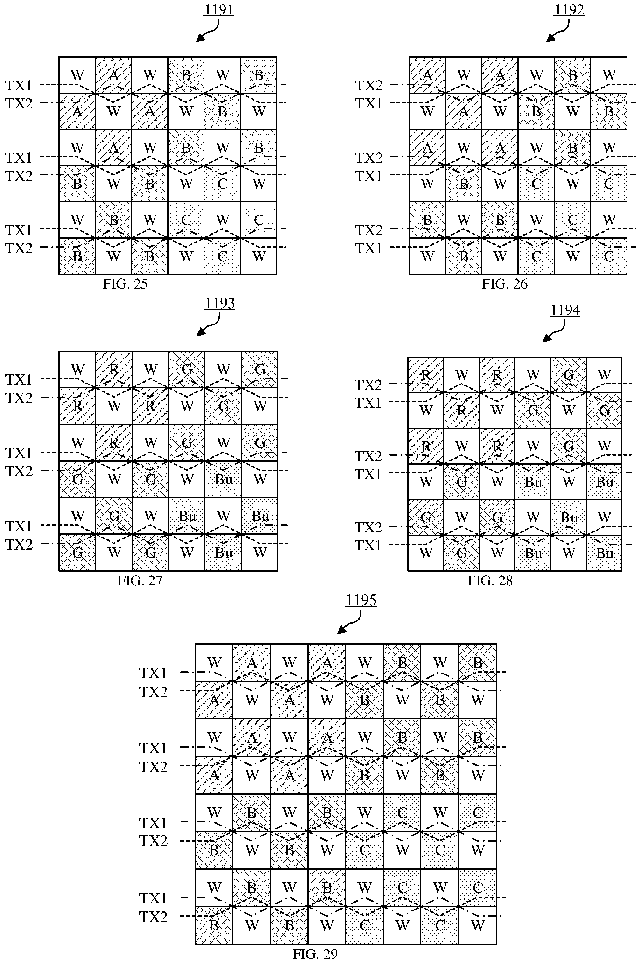

For example, FIG. 25 is a schematic diagram illustrating the arrangement of the pixels of yet another minimum repeating unit 1191 in the embodiments of the present disclosure. The minimum repeating unit has 6 rows and 6 columns, i.e., 36 pixels in total, and each of the sub-units has 3 rows and 3 columns, i.e., 9 pixels in total. The arrangement is as follows:

| | | | | | |
|---|---|---|---|---|---|
| W | A | W | B | W | B |
| A | W | A | W | B | W |
| W | A | W | B | W | B |
| B | W | B | W | C | W |
| W | B | W | C | W | C |
| B | W | B | W | C | W |

W represents the panchromatic pixel, A represents the first monochromatic pixel of the multiple monochromatic pixels, B represents the second monochromatic pixel of the multiple monochromatic pixels, and C represents the third monochromatic pixel of the multiple monochromatic pixels.

For example, as shown in FIG. 25, the panchromatic pixels in the first row and the second row are connected together by the first exposure control line TX1 in the shape of "W", to realize the independent control of the exposure time of these panchromatic pixels. The monochromatic pixels (pixels A and B) in the first row and the second row are connected together by the second exposure control line TX2 in the shape of "W", to realize the independent control of the exposure time of these monochromatic pixels. The panchromatic pixels in the third row and the fourth row are connected together by the first exposure control line TX1 in the shape of "W" to realize the independent control of the exposure time of these panchromatic pixels. The monochromatic pixels (pixels A, B, and C) in the third row and the fourth row are connected together by the second exposure control line TX2 in the shape of "W" to realize the independent control of the exposure time of these monochromatic pixels. The panchromatic pixels in the fifth row and the sixth row are connected together by the first exposure control line TX1 in the shape of "W" to realize the independent control of the exposure time of these panchromatic pixels. The monochromatic pixels (pixels B and C) in the fifth row and the sixth row are connected together by the second exposure control line TX2 in the shape of "W" to realize the independent control of the exposure time of these monochromatic pixels.

For example, FIG. 26 is a schematic diagram illustrating the arrangement of the pixels of yet another minimum repeating unit 1192 in the embodiments of the present disclosure. The minimum repeating unit has 6 rows and 6 columns, i.e., 36 pixels in total, and each of the sub-units has 3 rows and 32 columns, i.e., 9 pixels in total. The arrangement is as follows:

| | | | | | |
|---|---|---|---|---|---|
| A | W | A | W | B | W |
| W | A | W | B | W | B |
| A | W | A | W | B | W |
| W | B | W | C | W | C |
| B | W | B | W | C | W |
| W | B | W | C | W | C |

W represents the panchromatic pixel, A represents the first monochromatic pixel of the multiple monochromatic pixels, B represents the second monochromatic pixel of the multiple monochromatic pixels, and C represents the third monochromatic pixel of the multiple monochromatic pixels.

For example, as shown in FIG. 26, the panchromatic pixels in the first row and the second row are connected together by the first exposure control line TX1 in the shape of "W", to realize the independent control of the exposure time of these panchromatic pixels. The monochromatic pixels (pixels A and B) in the first row and the second row are connected together by the second exposure control line TX2 in the shape of "W", to realize the independent control of the exposure time of these monochromatic pixels. The panchromatic pixels in the third row and the fourth row are connected together by the first exposure control line TX1 in the shape of "W" to realize the independent control of the exposure time of these panchromatic pixels. The monochromatic pixels (pixels A, B, and C) in the third row and the fourth row are connected together by the second exposure control line TX2 in the shape of "W" to realize the independent control of the exposure time of these monochromatic pixels. The panchromatic pixels in the fifth row and the sixth row are connected together by the first exposure control line TX1 in the shape of "W" to realize the independent control of the exposure time of these panchromatic pixels. The monochromatic pixels (pixels B and C) in the fifth row and the sixth row are connected together by the second exposure control line TX2 in the shape of "W" to realize the independent control of the exposure time of these monochromatic pixels.

For example, FIG. 27 is a schematic diagram illustrating the arrangement of the pixels of yet another minimum repeating unit 1193 in the embodiments of the present disclosure. FIG. 28 is a schematic diagram illustrating the arrangement of the pixels of yet another minimum repeating unit 1194 in the embodiments of the present disclosure. In the embodiments of FIG. 27 and FIG. 28, they correspond to the arrangements of FIG. 25 and FIG. 26 respectively, in which the first monochromatic pixel A is the red pixel R, the second monochromatic pixel B is the green pixel G, and the third monochromatic pixel C is the blue pixel Bu.

For example, in other embodiments, the first monochromatic pixel A is the red pixel R, the second monochromatic pixel B is the yellow pixel Y, and the third monochromatic pixel C is the blue pixel Bu. For example, in other embodiments, the first monochromatic pixel A is the magenta pixel M, the second monochromatic pixel B is the cyan pixel Cy, and the third monochromatic pixel C is the yellow pixel Y. The embodiments of the present disclosure include but are not limited to this. The specific connection of the circuit may refer to the above description, which will not be repeated here.

For example, FIG. 29 is a schematic diagram illustrating the arrangement of the pixels of yet another minimum repeating unit 1195 in the embodiments of the present disclosure. The minimum repeating unit has 8 rows and 8 columns, i.e., 64 pixels in total, and each of the sub-units has 4 rows and 4 columns, i.e., 16 pixels in total. The arrangement is as follows:

| | | | | | | | |
|---|---|---|---|---|---|---|---|
| W | A | W | A | W | B | W | B |
| A | W | A | W | B | W | B | W |
| W | A | W | A | W | B | W | B |
| A | W | A | W | B | W | B | W |
| W | B | W | B | W | C | W | C |
| B | W | B | W | C | W | C | W |
| W | B | W | B | W | C | W | C |
| B | W | B | W | C | W | C | W |

W represents the panchromatic pixel, A represents the first monochromatic pixel of the multiple monochromatic pixels, B represents the second monochromatic pixel of the multiple monochromatic pixels, and C represents the third monochromatic pixel of the multiple monochromatic pixels.

For example, as shown in FIG. 29, the panchromatic pixels in the first row and the second row are connected together by the first exposure control line TX1 in the shape of "W", to realize the independent control of the exposure time of these panchromatic pixels. The monochromatic pixels (pixels A and B) in the first row and the second row are connected together by the second exposure control line TX2 in the shape of "W", to realize the independent control of the exposure time of these monochromatic pixels. The panchromatic pixels in the third row and the fourth row are connected together by the first exposure control line TX1 in the shape of "W" to realize the independent control of the exposure time of these panchromatic pixels. The monochromatic pixels (pixels A and B) in the third row and the fourth row are connected together by the second exposure control line TX2 in the shape of "W" to realize the independent control of the exposure time of these monochromatic pixels. The panchromatic pixels in the fifth row and the sixth row are connected together by the first exposure control line TX1 in the shape of "W" to realize the independent control of the exposure time of these panchromatic pixels. The monochromatic pixels (pixels B and C) in the fifth row and the sixth row are connected together by the second exposure control line TX2 in the shape of "W" to realize the independent control of the exposure time of these monochromatic pixels. The panchromatic pixels in the seventh row and the eighth row are connected together by the first exposure control line TX1 in the shape of "W" to realize the independent control of the exposure time of these panchromatic pixels. The monochromatic pixels (pixels B and C) in the seventh row and the eighth row are connected together by the second exposure control line TX2 in the shape of "W" to realize the independent control of the exposure time of these monochromatic pixels.

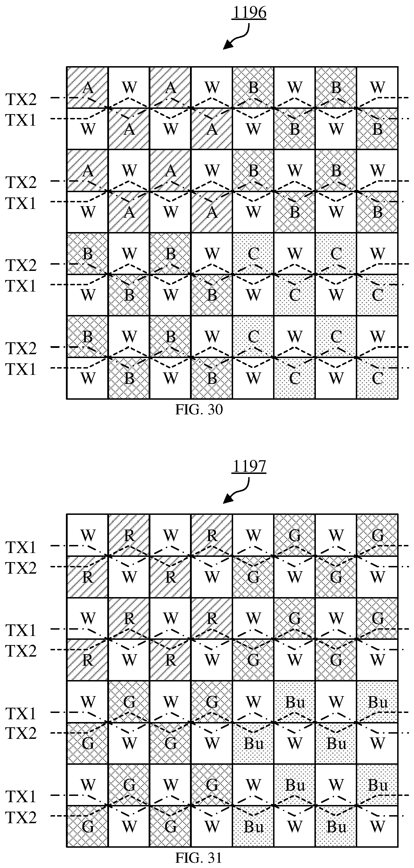

For example, FIG. 30 is a schematic diagram illustrating the arrangement of the pixels of yet another minimum repeating unit 1196 in the embodiments of the present disclosure. The minimum repeating unit has 8 rows and 8 columns, i.e., 64 pixels in total, and each of the sub-units has 4 rows and 4 columns, i.e., 16 pixels in total. The arrangement is as follows:

| | | | | | | | |
|---|---|---|---|---|---|---|---|
| A | W | A | W | B | W | B | W |
| W | A | W | A | W | B | W | B |

| | | | | | | | |
|---|---|---|---|---|---|---|---|
| A | W | A | W | B | W | B | W |
| W | A | W | A | W | B | W | B |
| B | W | B | W | C | W | C | W |
| W | B | W | B | W | C | W | C |
| B | W | B | W | C | W | C | W |
| W | B | W | B | W | C | W | C |

W represents the panchromatic pixel, A represents the first monochromatic pixel of the multiple monochromatic pixels, B represents the second monochromatic pixel of the multiple monochromatic pixels, and C represents the third monochromatic pixel of the multiple monochromatic pixels.

For example, as shown in FIG. 30, the panchromatic pixels in the first row and the second row are connected together by the first exposure control line TX1 in the shape of "W", to realize the independent control of the exposure time of these panchromatic pixels. The monochromatic pixels (pixels A and B) in the first row and the second row are connected together by the second exposure control line TX2 in the shape of "W", to realize the independent control of the exposure time of these monochromatic pixels. The panchromatic pixels in the third row and the fourth row are connected together by the first exposure control line TX1 in the shape of "W" to realize the independent control of the exposure time of these panchromatic pixels. The monochromatic pixels (pixels A and B) in the third row and the fourth row are connected together by the second exposure control line TX2 in the shape of "W" to realize the independent control of the exposure time of these monochromatic pixels. The panchromatic pixels in the fifth row and the sixth row are connected together by the first exposure control line TX1 in the shape of "W" to realize the independent control of the exposure time of these panchromatic pixels. The monochromatic pixels (pixels B and C) in the fifth row and the sixth row are connected together by the second exposure control line TX2 in the shape of "W" to realize the independent control of the exposure time of these monochromatic pixels. The panchromatic pixels in the seventh row and the eighth row are connected together by the first exposure control line TX1 in the shape of "W" to realize the independent control of the exposure time of these panchromatic pixels. The monochromatic pixels (pixels B and C) in the seventh row and the eighth row are connected together by the second exposure control line TX2 in the shape of "W" to realize the independent control of the exposure time of these monochromatic pixels.

For example, FIG. 31 is a schematic diagram illustrating the arrangement of the pixels of yet another minimum repeating unit 1197 in the embodiments of the present disclosure. FIG. 32 is a schematic diagram illustrating the arrangement of the pixels of yet another minimum repeating unit 1198 in the embodiments of the present disclosure. In the embodiments of FIG. 31 and FIG. 32, they correspond to the arrangements of FIG. 29 and FIG. 30 respectively, in which the first monochromatic pixel A is the red pixel R, the second monochromatic pixel B is the green pixel G, and the third monochromatic pixel C is the blue pixel Bu.

For example, in other embodiments, the first monochromatic pixel A is the red pixel R, the second monochromatic pixel B is the yellow pixel Y, and the third monochromatic pixel C is the blue pixel Bu. For example, in other embodiments, the first monochromatic pixel A is the magenta pixel M, the second monochromatic pixel B is the cyan pixel Cy, and the third monochromatic pixel C is the yellow pixel Y. The embodiments of the present disclosure include but are not limited to this. The specific connection of the circuit may refer to the above description, which will not be repeated here.

It can be seen from the above embodiments that, as shown in FIG. 17 to FIG. 32, the image sensor 10 (shown in FIG. 1) includes multiple monochromatic pixels and multiple panchromatic pixels W which are arranged in an array, in which the monochromatic pixels and the panchromatic pixels are arranged alternatively in the rows and columns.

For example, in the rows, the panchromatic pixel, the monochromatic pixel, the panchromatic pixel, the monochromatic pixel ... are alternately arranged.

For example, in the columns, the panchromatic pixel, the monochromatic pixel, the panchromatic pixel, the monochromatic pixel ... are alternately arranged.

Referring to FIG. 16, the first exposure control line TX1 is electrically connected to the control terminals TG of the exposure control circuits 116 (for example, the gate of the transfer transistor 112) of the panchromatic pixels W in the (2n-1)-th row and the 2n-th row, and the second exposure control line TX2 is electrically connected to the control terminals TG of the exposure control circuits 116 (for example, the gate of the transfer transistor 112) of the monochromatic pixels in the (2n-1)-th row and the 2n-th row, where n is a natural number greater than or equal to 1.

For example, when n=1, the first exposure control line TX1 is electrically connected to the control terminals TG of the exposure control circuits 116 of the panchromatic pixels W in the first row and the second row, and the second exposure control line TX2 is electrically connected to the control terminals TG of the exposure control circuits 116 of the monochromatic pixels in the first row and the second row. When n=2, the first exposure control line TX1 is electrically connected to the control terminals TG of the exposure control circuits 116 of the panchromatic pixels W in the third row and the fourth row, and the second exposure control line TX2 is electrically connected to the control terminals TG of the exposure control circuits 116 of the monochromatic pixels in the third row and the fourth row, and so on, which will not be repeated here.

In some embodiments, the first exposure time is less than the second exposure time. The first exposure time is determined according to the n-well layer 1172 (shown in FIG. 4A) of the panchromatic pixel, and the second exposure time may be determined according to the n-well layers 1172 (shown in FIG. 4A) of the monochromatic pixels.

Referring to FIG. 33, the embodiments of the present disclosure provide a camera assembly 40. The camera assembly 40 includes the image sensor 10 as described in any one of the above embodiments, a processing chip 20, and a lens 30. The image sensor 10 is electrically connected to the processing chip 20. The lens 30 is provided in the optical path of the image sensor 10. The image sensor 10 may receive light passing through the lens 30 to obtain an original image. The processing chip 20 can receive the original image output by the image sensor 10 and perform subsequent processing on the original image.

The embodiments of the present disclosure further provide an image capturing method that can be applied to the camera assembly 40 of FIG. 33. As shown in FIG. 34, the image capturing method includes operations as follows.

At block 01, the exposure of the two-dimensional pixel array is controlled to obtain a panchromatic original image and a color original image.

At block 02, the color original image is processed in such a manner that all pixels of each sub-unit are combined as a monochromatic large pixel corresponding to the single color in the sub-unit, and the pixel values of the monochromatic large pixels are output to obtain a color intermediate image.

At block 03, the panchromatic original image is processed to obtain a panchromatic intermediate image.

At block 04, the color intermediate image and/or the panchromatic intermediate image is processed to obtain a target image.

Referring to FIG. 1 and FIG. 33, the image capturing method in the embodiments of the present disclosure can be implemented by the camera assembly 40. Among them, block 01 can be implemented by the image sensor 10, and blocks 02, 03, and 04 can be implemented by the processing chip 20. In other words, exposure can be performed on the image sensor 10 to obtain a panchromatic original image and a color original image. The processing chip 20 may be configured to process the color original image in such a manner that all pixels of each sub-unit are combined as a monochromatic large pixel corresponding to the single color in the sub-unit, and output the pixel values of the monochromatic large pixels to obtain a color intermediate image. The processing chip 20 may also be configured to process the panchromatic original image to obtain a panchromatic intermediate image, and process the color intermediate image and/or the panchromatic intermediate image to obtain a target image.

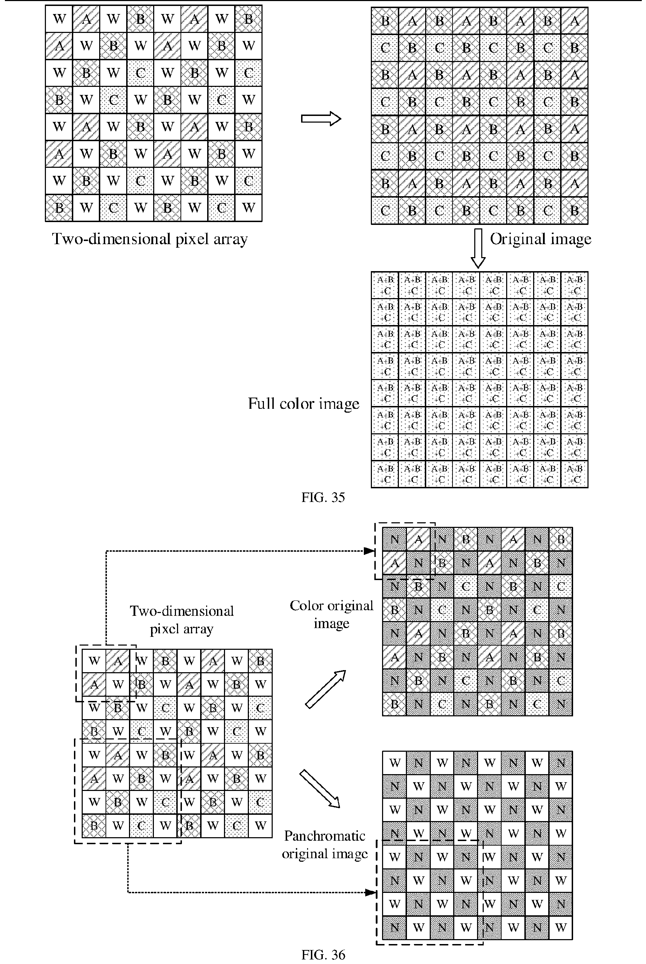

Referring to FIG. 35, in the related art, in the case where the pixel array of the image sensor includes both the panchromatic pixels and monochromatic pixels, when the image sensor works, the image sensor fits the pixel value of each panchromatic pixel in the pixel array into the pixel values of other monochromatic pixels, to output an original image including only monochromatic pixels. Specifically, it is illustrated by taking a case where the pixel A is a red pixel R, the pixel B is a green pixel G, and the pixel C is a blue pixel Bu as an example, after the column processing unit in the image sensor reads out the pixel values of the multiple red pixels R, the pixel values of the multiple green pixels G, the pixel values of the multiple blue pixels Bu, and the pixel values of the multiple panchromatic pixels W, the image sensor first fits the pixel value of each panchromatic pixel W into the pixel values of the red pixel R, green pixel G, and blue pixel Bu that are adjacent to that panchromatic pixel, and converts the image in non-Bayer array arrangement into an original image in Bayer array arrangement for output. Then, the processing chip can perform subsequent processing on the original image, for example, the processing chip may perform value-interpolation processing on the original image to obtain a full color image (in the full color image, the pixel value of each pixel is composed of three components i.e., red component, green component and blue component). In this processing method, the image sensor needs to execute a complex algorithm, and the amount of calculation thereof is relatively large. In addition, since the Qualcomm platform does not support the processing of images in non-Bayer array arrangement, additional hardware (such as an additional processing chip) may have to be added in the image sensor to convert the image in non-Bayer array arrangement into the original image in Bayer array arrangement.

The image capturing method and the camera assembly 40 in the embodiments of the present disclosure can reduce the amount of calculation of the image sensor and avoid an additional hardware from being added into the image sensor.

Specifically, referring to FIG. 1 and FIG. 36, when the user requests to take a photo, the vertical driving unit 12 in the image sensor 10 controls the exposure of the multiple panchromatic pixels and the multiple monochromatic pixels in the two-dimensional pixel array, and the column processing unit 14 reads out the pixel value of each panchromatic pixel and the pixel value of each monochromatic pixel. The image sensor 10 does not perform the operation of fitting the pixel values of the panchromatic pixels into the pixel values of the monochromatic pixels, but directly outputs a panchromatic original image based on the pixel values of the multiple panchromatic pixels, and directly outputs a color original image based on the pixel values of the multiple monochromatic pixels

As shown in FIG. 36, the panchromatic original image includes multiple panchromatic pixels W and multiple null pixels N (NULL). The null pixels are neither panchromatic pixels nor monochromatic pixels. It may be considered that no pixel is provided at the positions where the null pixels N are located in the panchromatic original image, or the pixel value of each null pixel can be regarded as zero. Comparing the two-dimensional pixel array with the panchromatic original image, it can be seen that each sub-unit in the two-dimensional pixel array includes two panchromatic pixels W and two monochromatic pixels (monochromatic pixels A, monochromatic pixels B, or monochromatic pixels C), and the panchromatic original image also has sub-units each corresponding to one sub-unit in the two-dimensional pixel array. Each sub-unit of the panchromatic original image includes two panchromatic pixels W and two null pixels N, in which the positions of the two null pixels N corresponds to the positions of the two monochromatic pixels in the corresponding sub-unit of the two-dimensional pixel array.

Similarly, the color original image includes multiple monochromatic pixels and multiple null pixels N. The null pixels are neither panchromatic pixels nor monochromatic pixels. It may be considered that no pixel is provided at the positions where the null pixels N are located in the color original image, or the pixel value of each null pixel can be regarded as zero. Comparing the two-dimensional pixel array with the color original image, it can be seen that each sub-unit in the two-dimensional pixel array includes two panchromatic pixels W and two monochromatic pixels, and the color original image also has sub-units each corresponding to one sub-unit in the two-dimensional pixel array. Each sub-unit of the color original image includes two monochromatic pixels and two null pixels N, in which the positions of the two null pixels N corresponds to the positions of the two panchromatic pixels W in the corresponding sub-unit of the two-dimensional pixel array.

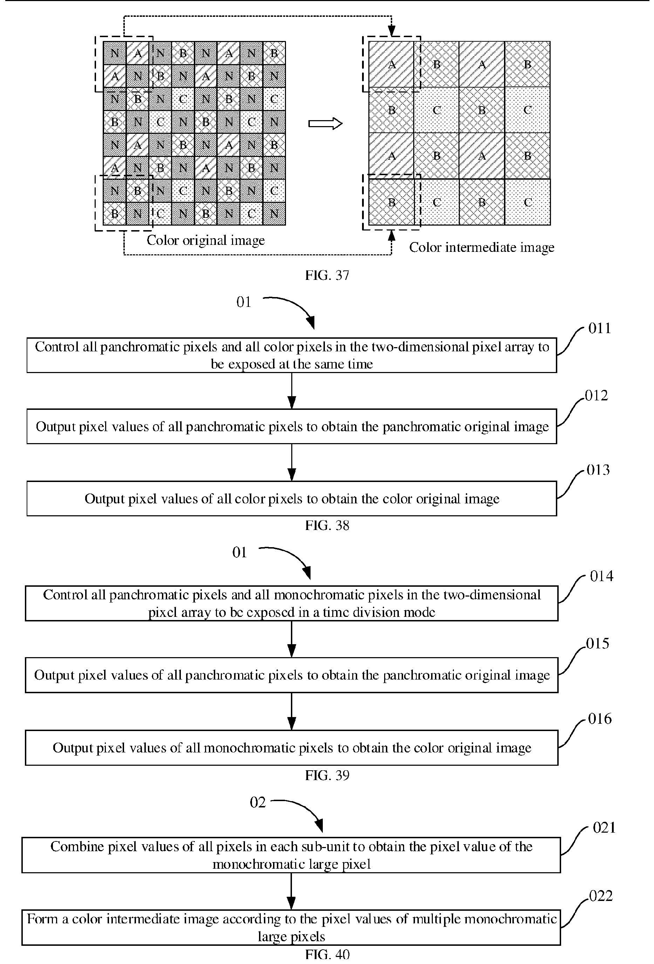

After the processing chip 20 receives the panchromatic original image and the color original image output by the image sensor 10, it can further process the panchromatic original image to obtain a panchromatic intermediate image, and further process the color original image to obtain a color intermediate image. For example, the color original image can be transformed into the color intermediate image in a way shown in FIG. 37. As shown in FIG. 37, the color original image includes multiple sub-units, and each of the sub-units includes multiple null pixels N and multiple monochromatic color pixels (also called monochromatic pixels). Specifically, some sub-units each include two null pixels N and two monochromatic pixels A, some sub-units each include two null pixels N and two monochromatic pixels B, and some sub-units each include two null pixels N and two monochromatic pixels C. The processing chip 20 may combine all pixels in each sub-unit including the null pixels N and the monochromatic pixels A, as a monochromatic large pixel A corresponding to the single color A in the sub-unit; may combine all pixels in each sub-unit including the null pixels N and the monochromatic pixels B, as a monochromatic large pixel B corresponding to the single color B in the sub-unit; and may combine all pixels in each sub-unit including the null pixels N and the monochromatic pixels C, as a monochromatic large pixel C corresponding to the single color C in the sub-unit. In this way, the processing chip 20 can obtain a color intermediate image based on the multiple monochromatic large pixels A, the multiple monochromatic large pixels B, and the multiple monochromatic large pixels C. If the color original image including the multiple null pixels N is regarded as an image with a second resolution, the color intermediate image obtained in the way shown in FIG. 38 is an image with a first resolution, where the first resolution is smaller than the second resolution. After the processing chip 20 obtains the panchromatic intermediate image and the color intermediate image, the panchromatic intermediate image and/or the color intermediate image may be further processed to obtain the target image. Specifically, the processing chip 20 may process only the panchromatic intermediate image to obtain the target image; or the processing chip 20 may also process only the color intermediate image to obtain the target image; or the processing chip 20 may also process both the panchromatic intermediate image and the color intermediate image to obtain the target image. The processing chip 20 can determine the processing mode of the two intermediate images according to actual requirements.

In the image capturing method of the embodiments of the present disclosure, the image sensor 10 can directly output the panchromatic original image and the color original image. The subsequent processing of the panchromatic original image and the color original image is performed by the processing chip 20, and the image sensor 10 does not need to fit the pixel values of the panchromatic pixels W into the pixel values of the monochromatic pixels. Therefore, the amount of calculation of the image sensor 10 is reduced, and there is no need to add new hardware into the image sensor 10 to support image processing of the image sensor 10, which simplifies the design of the image sensor 10.

In some embodiments, block 01 of controlling the exposure of the two-dimensional pixel array to obtain the panchromatic original image and the color original image can be implemented in various ways.

Referring to FIG. 38, in an example, block 01 includes operations as follows.

At block 011, all panchromatic pixels and all monochromatic pixels in the two-dimensional pixel array are controlled to be exposed at the same time.

At block 012, pixel values of all panchromatic pixels are output to obtain the panchromatic original image.

At block 013, pixel values of all monochromatic pixels are output to obtain the color original image.

Referring to FIG. 33, all of blocks 011, 012, and 013 can be implemented by the image sensor 10. In other words, simultaneous exposure is performed on all panchromatic pixels and all monochromatic pixels in the image sensor 10. The image sensor 10 may output the pixel values of all panchromatic pixels to obtain the panchromatic original image, and may also output the pixel values of all monochromatic pixels to obtain the color original image.

Referring to FIG. 2 and FIG. 16, the panchromatic pixels and the monochromatic pixels can be exposed simultaneously, where the exposure time of the panchromatic pixel can be less than or equal to the exposure time of the monochromatic pixel. Specifically, when the first exposure time of the panchromatic pixel is equal to the second exposure time of the monochromatic pixel, the exposure start time and the exposure stop time of the panchromatic pixel are the same as the exposure start time and the exposure stop time of the monochromatic pixel, respectively. When the first exposure time is less than the second exposure time, the exposure start time of the panchromatic pixel is later than or equal to the exposure start time of the monochromatic pixel, and the exposure stop time of the panchromatic pixel is earlier than the exposure stop time of the monochromatic pixel; or when the first exposure time is less than the second exposure time, the exposure start time of the panchromatic pixel is later than the exposure start time of the monochromatic pixel, and the exposure stop time of the panchromatic pixel is earlier than or equal to the exposure stop time of the monochromatic pixel. After the exposure of the panchromatic pixels and the exposure of the monochromatic pixels all end, the image sensor 10 outputs the pixel values of all panchromatic pixels to obtain the panchromatic original image, and outputs the pixel values of all monochromatic pixels to obtain the color original image. Among them, the panchromatic original image can be output before the color original image; or, the color original image can be output before the panchromatic original image; or, the panchromatic original image and the color original image can be output at the same time. The output order of the two original images is not limited here. The simultaneous exposure of the panchromatic pixels and the monochromatic pixels can shorten the acquisition time of the panchromatic original image and the color original image, and speed up the process of acquiring the panchromatic original image and the color original image. The simultaneous exposure of the panchromatic pixels and the monochromatic pixels has great advantages in snap shotting, continuous shotting and other modes requiring a high image output speed.

Referring to FIG. 39, in another example, block 01 includes operations as follows

At block 014, all panchromatic pixels and all monochromatic pixels in the two-dimensional pixel array are controlled to be exposed in a time division mode.

At block 015, pixel values of all panchromatic pixels are output to obtain the panchromatic original image.

At block 016, pixel values of all monochromatic pixels are output to obtain the color original image.

Referring to FIG. 33, all of blocks 014, 015, and 016 can be implemented by the image sensor 10. In other words, time division exposure is performed on all the panchromatic pixels and all the monochromatic pixels in the image sensor 10. The image sensor 10 may output the pixel values of all panchromatic pixels to obtain the panchromatic original image, and may also output the pixel values of all monochromatic pixels to obtain the color original image.

Specifically, the panchromatic pixels and the monochromatic pixels may be exposed in a time division mode, where the exposure time of the panchromatic pixels may be less than or equal to the exposure time of the monochromatic pixels. Specifically, regardless of whether the first exposure time is equal to the second exposure time, the time division exposure of all panchromatic pixels and all monochromatic pixels may be performed in such a manner that: (1) the exposure of all the panchromatic pixels is first performed for the first exposure time, and after the exposure of all the panchromatic pixels ends, the exposure of all the monochromatic pixels is performed for the second exposure time; or (2) the exposure of all the monochromatic pixels is first performed for the second exposure time, and after the exposure of all the monochromatic pixels ends, the exposure of all the panchromatic pixels is performed for the first exposure time. After the exposure of all the panchromatic pixels and the exposure of all the monochromatic pixels end, the image sensor 10 outputs the pixel values of all the panchromatic pixels to obtain the panchromatic original image, and outputs the pixel values of all the monochromatic pixels to obtain the color original image. Among them, the panchromatic original image and the color original image may be output in such a manner that: (1) in the case where the exposure of the panchromatic pixels is performed before the exposure of the monochromatic pixels, the image sensor 10 can output the panchromatic original image during the exposure of the monochromatic pixels, or output the panchromatic original image and the color original image in sequence after the exposure of the monochromatic pixels ends; (2) in the case where the exposure of the monochromatic pixels is performed before the exposure of the panchromatic pixels, the image sensor 10 can output the color original images during the exposure of the panchromatic pixels, or output the color original image and the panchromatic original image in sequence after the exposure of the panchromatic pixels ends; or (3) no matter which of the panchromatic pixels and the monochromatic pixels are exposed first, the image sensor 10 can output the panchromatic original image and the color original image at the same time after the exposure of all the pixels ends. In this example, the control logic of the time division exposure of the panchromatic pixels and the monochromatic pixels is relatively simple.

The image sensor 10 can simultaneously have the functions of performing the simultaneous exposure of the panchromatic pixels and the monochromatic pixels, and performing the time division exposure of the panchromatic pixels and the monochromatic pixels, as shown in FIG. 38 and FIG. 39. The specific exposure mode adopted by the image sensor 10 in the process of capturing images can be selected according to actual needs. For example, the simultaneous exposure can be adopted in the snap shotting mode, the continuous shotting mode or the like to meet the needs of rapid image output; and the time division exposure can be adopted in the ordinary shotting mode to simplify the control logic and the like.

In the two examples shown in FIG. 38 and FIG. 39, the exposure sequence of the panchromatic pixels and the monochromatic pixels can be controlled by the control unit 13 in the image sensor 10.

In the two examples shown in FIG. 38 and FIG. 39, the exposure time of the panchromatic pixels can be controlled by the first exposure signal, and the exposure time of the monochromatic pixels can be controlled by the second exposure signal.

Specifically, referring to FIG. 16, as an example, the image sensor 10 may use the first exposure signal to control at least two adjacent panchromatic pixels in the first diagonal direction to be exposed for the first exposure time, and use the second exposure signal to control at least two adjacent monochromatic pixels in the second diagonal direction to be exposed for the second exposure time, where the first exposure time may be less than or equal to the second exposure time. Specifically, the vertical driving unit 12 in the image sensor 10 transmits the first exposure signal through the first exposure control line TX1, to control the at least two adjacent panchromatic pixels in the first diagonal direction to be exposed for the first exposure time; and the vertical driving unit 12 transmits the second exposure signal through the second exposure control line TX2, to control the at least two adjacent panchromatic pixels in the second diagonal direction to be exposed for the second exposure time. After the exposure of all the panchromatic pixels and all the monochromatic pixels ends, as shown in FIG. 37, the image sensor 10 does not fit the pixel values of the multiple panchromatic pixels into the pixel values of the monochromatic pixels, but directly outputs one panchromatic original image and one color original image.

Referring to FIG. 2 and FIG. 17, as another example, the image sensor 10 can use the first exposure signal to control the panchromatic pixels in the (2n-1)-th row and the 2n-th row to be exposed for the first exposure time, and use the second exposure signal to control the monochromatic pixels in the (2n-1)-th row and the 2n-th row to be exposed for the second exposure time, where the first exposure time may be less than or equal to the second exposure time. Specifically, the first exposure control line TX1 of the image sensor 10 is connected to the control terminals TG of all panchromatic pixels in the (2n-1)-th row and the 2n-th row, and the second exposure control line TX2 is connected to the control terminals TG of all monochromatic pixels in the (2n-1)-th row and the 2n-th row. The vertical driving unit 12 transmits the first exposure signal through the first exposure control line TX1 to control the panchromatic pixels in the (2n-1)-th row and the 2n-th row to be exposed for the first exposure time, and transmits the second exposure signal through the second exposure control line TX2 to control the monochromatic pixels in the (2n-1)-th row and the 2n-th row to be exposed for the second exposure time. After the exposure of all the panchromatic pixels and the exposure of all the monochromatic pixels end, as shown in FIG. 36, the image sensor 10 does not fit the pixel values of the multiple panchromatic pixels into the pixel values of the monochromatic pixels, but directly outputs one panchromatic original image and one color original image.

In some embodiments, the processing chip 20 may determine, according to an ambient brightness, a relative relationship between the first exposure time and the second exposure time. For example, the image sensor 10 may first control the panchromatic pixels to be exposed and output the panchromatic original image, and the processing chip 20 analyzes the pixel values of the multiple panchromatic pixels in the panchromatic original image to determine the ambient brightness. When the ambient brightness is less than or equal to a brightness threshold, the image sensor 10 controls the panchromatic pixels to be exposed for the first exposure time that is equal to the second exposure time; and when the ambient brightness is greater than the brightness threshold, the image sensor 10 controls the panchromatic pixels to be exposed for the first exposure time that is less than the second exposure time. When the ambient brightness is greater than the brightness threshold, the relative relationship between the first exposure time and the second exposure time can be determined according to a brightness difference between the ambient brightness and the brightness threshold. For example, the greater the brightness difference, the smaller the ratio of the first exposure time to the second exposure time. For example, when the brightness difference is within a first range [a, b), the ratio of the first exposure time to the second exposure time is V1:V2; when the brightness difference is within a second range [b, c), the ratio of the first exposure time to the second exposure time is V1:V3; when the brightness difference is greater than or equal to c, the ratio of the first exposure time to the second exposure time is V1:V4, where V1 < V2 < V3 < V4.

Referring to FIG. 40, in some embodiments, block 02 includes operations as follows.

At block 021, the pixel values of all pixels in each sub-unit are combined to obtain the pixel value of the monochromatic large pixel.

At block 022, a color intermediate image is formed according to the pixel values of multiple monochromatic large pixels, where the color intermediate image has a first resolution.

Referring to FIG. 33, in some embodiments, both block 021 and block 022 can be implemented by the processing chip 20. In other words, the processing chip 20 can be configured to combine the pixel values of all pixels in each sub-unit to obtain the pixel value of each monochromatic large pixel, and form the color intermediate image based on the pixel values of multiple monochromatic large pixels. The color intermediate image has the first resolution. The color intermediate image has the first resolution.

Specifically, as shown in FIG. 37, for the monochromatic large pixel A, the processing chip 20 may add the pixel values of all pixels in each sub-unit including the null pixels N and the monochromatic pixels A, and use the result of the addition as the pixel value of the monochromatic large pixel A corresponding to the sub-unit. The pixel value of the null pixel N can be regarded as zero, which is true for the following. The processing chip 20 may add the pixel values of all pixels in each sub-unit including the null pixels N and the monochromatic pixels B, and use the result of the addition as the pixel value of the monochromatic large pixel B corresponding to the sub-unit. The processing chip 20 may add the pixel values of all pixels in each sub-unit including the null pixels N and the monochromatic pixels C, and use the result of the addition as the pixel value of the monochromatic large pixel C corresponding to the sub-unit. Thus, the processing chip 20 can obtain the pixel values of multiple monochromatic large pixels A, the pixel values of multiple monochromatic large pixels B, and the pixel values of multiple monochromatic large pixels C. The processing chip 20 then forms the color intermediate image according to the pixel values of the multiple monochromatic large pixels A, the pixel values of the multiple monochromatic large pixels B, and the pixel values of the multiple monochromatic large pixels C. As shown in FIG. 37, when the single color A is red R, the single color B is green G, and the single color C is blue Bu, the color intermediate image is an image in Bayer array arrangement. Of course, the manner in which the processing chip 20 obtains the color intermediate image is not limited to this.

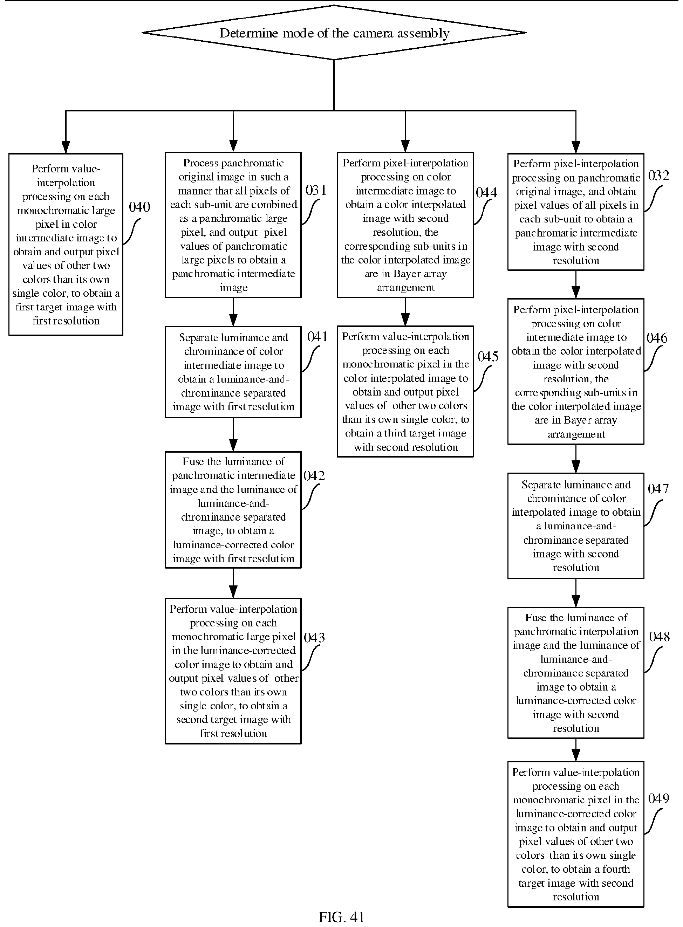

In some embodiments, referring to FIG. 33 and FIG. 41, when the camera assembly 40 is in different modes, there are different target images corresponding to the different modes. The processing chip 20 first determines which mode the camera assembly 40 is in, and then performs corresponding processing on the color intermediate image and/or the panchromatic intermediate image according to the mode of the camera assembly 40, to obtain the target image corresponding to the mode. The target image includes at least four target images: a first target image, a second target image, a third target image, and a fourth target image. The camera assembly 40 may be in modes including at least: (1) a preview mode, in which the target image may be the first target image or the second target image; (2) an imaging mode, in which the target image may be the second target image, the third target image, or the fourth target image; (3) both the preview mode and a low power consumption mode, in which the target image may be the first target image; (4) both the preview mode and a non-low power consumption mode, in which the target image may be the second target image; (5) both the imaging mode and the low power consumption mode, in which the target image may be the second target image or the third target image at this time; and (6) both the imaging mode and the non-low power consumption mode, in which the target image may be the fourth target image.

Referring to FIG. 41, in an example, when the target image is the first target image, block 04 includes an operation as follows:
At block 040, value-interpolation processing is performed on each of the monochromatic large pixels in the color intermediate image to obtain and output the pixel values of the other two colors than its own single color, so as to obtain the first target image with the first resolution.

Referring to FIG. 33, block 040 can be implemented by the processing chip 20. In other words, the processing chip 20 can be configured to perform value-interpolation processing on each of the monochromatic large pixels in the color intermediate image to obtain and output the pixel values of the other two colors than its own single color, so as to obtain the first target image with the first resolution.

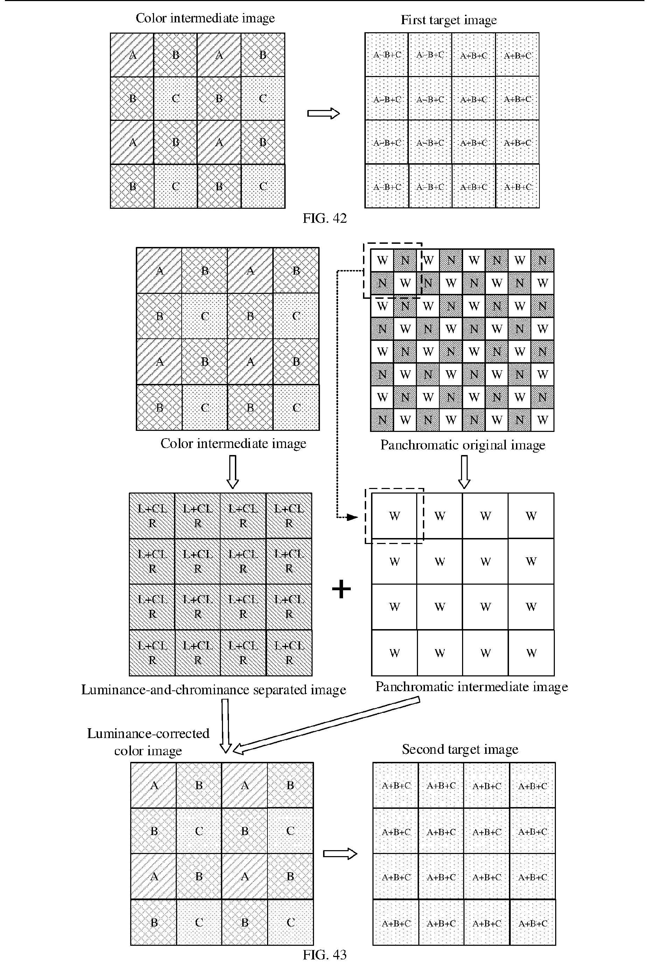

Specifically, referring to FIG. 42, assuming that the monochromatic large pixel A is a red pixel R, the monochromatic large pixel B is a green pixel G, and the monochromatic large pixel C is a blue pixel Bu, in this case, the color intermediate image is in Bayer array arrangement, and the processing chip 20 needs to perform demosaicing processing (that is, value-interpolation processing) on the color intermediate image, so that the pixel value of each monochromatic large pixel has three components of R, G, and B at the same time. For example, a linear interpolation method may be used to calculate, for each monochromatic large pixel, the pixel values of the other two colors other than the single color of this monochromatic large pixel. Taking the monochromatic large pixel C_{2,2} ("C_{2,2}" means the pixel C in the second row and second column counting from the upper left corner) as an example, the pixel value P(C_{2,2}) of the monochromatic large pixel C_{2,2} only has the component of color C, it is necessary to calculate the pixel value P(A_{2,2}) of color A and the pixel value P(B_{2,2}) of color B for the position of this monochromatic large pixel C, specifically, P(A_{2,2}) = α•P(A_{3,1}) + α₂•P(A_{3,3}) + α₃•P(A_{1,3}) + α₄•P(A_{1,1}), P(B_{2,2}) = β₁•P(B_{1,2}) + β₂•P(B_{2,1}) + β₃•P(B_{2,3}) + β₄•P(B_{3,2}), where α₁ to α₄ and β₁ to β₄ are interpolation coefficients, and α₁+α₂+α₃+α₄=1, β₁+β₂+β₃+β₄=1. The calculation of P(A2,2) and P(B2,2) above are only exemplary. P(A2,2) and P(B_{2,2}) can also be calculated by other value-interpolation methods besides the linear interpolation, which is not limited here.

After the processing chip 20 calculates the pixel values of the three components for each monochromatic large pixel, it can calculate the final pixel value corresponding to the monochromatic large pixel based on the three pixel values, i.e., A+B+C. It should be noted that, "A+B+C" here does not mean that three pixel values are directly added to obtain the final pixel value of the monochromatic large pixel, but only means that the monochromatic large pixel includes the three color components of A, B, and C. The processing chip 20 may form the first target image according to the final pixel values of the multiple monochromatic large pixels. Since the color intermediate image has the first resolution, the first target image is obtained by performing the value-interpolation processing on the color intermediate image, and the processing chip 20 does not perform pixel-interpolation processing on the color intermediate image, therefore, the first target image also has the first resolution. The processing algorithm adopted for the processing chip 20 to process the color intermediate image to obtain the first target image is relatively simple, and the processing speed is fast. When the camera assembly 40 is in both the preview mode and the low power consumption mode, the first target image may be adopted as the preview image, which can not only meet the requirement of the preview mode for the image output speed, but also save the power consumption of the camera assembly 40.

Referring to FIG. 41 again, in another example, when the target image is the second target image, block 03 includes an operation as follows:
At block 031, the panchromatic original image is processed in such a manner that all pixels of each sub-unit are combined as a panchromatic large pixel, and the pixel values of the panchromatic large pixels are output to obtain a panchromatic intermediate image, where the panchromatic intermediate image has the first resolution.

In addition, block 04 includes operation as follows:
At Block 041, luminance and chrominance of the color intermediate image are separated to obtain a luminance-and-chrominance separated image with the first resolution.

At Block 042, the luminance of the panchromatic intermediate image and the luminance of the luminance-and-chrominance separated image are fused, to obtain a luminance-corrected color image with the first resolution.

At Block 043, value-interpolation processing is performed on each monochromatic large pixel in the luminance-corrected color image to obtain and output the pixel values of the other two colors than its own single color, so as to obtain the second target image with the first resolution.

Referring to FIG. 33, blocks 031, 041, 042 and 043 can all be implemented by the processing chip 20. In other words, the processing chip 20 can be configured to process the panchromatic original image in such a manner that all pixels of each sub-unit are combined as a panchromatic large pixel, and output the pixel values of the panchromatic large pixels to obtain the panchromatic intermediate image, where the panchromatic intermediate image has the first resolution. The processing chip 20 can also be configured to separate the luminance and chrominance of the color intermediate image to obtain a luminance-and-chrominance separated image with the first resolution, fuse the luminance of the panchromatic intermediate image and the luminance of the luminance-and-chrominance separated image to obtain a luminance-corrected image with the first resolution, and perform the value-interpolation processing on each monochromatic large pixel in the luminance-corrected color image to obtain and output the pixel values of the other two colors than its own single color, so as to obtain the second target with the first resolution image.

Specifically, the panchromatic original image can be transformed into the panchromatic intermediate image in a way shown in FIG. 43. As shown in FIG. 43, the panchromatic original image includes multiple sub-units, and each sub-unit includes two null pixels N and two panchromatic pixels W. The processing chip 20 may combine all pixels in each sub-unit including the null pixels N and the panchromatic pixels W, as the panchromatic large pixel W corresponding to the sub-unit. Thus, the processing chip 20 can form the panchromatic intermediate image based on the multiple panchromatic large pixels W. If the panchromatic original image including multiple null pixels N is regarded as an image with the second resolution, the panchromatic intermediate image obtained in the way shown in FIG. 43 is an image with the first resolution, where the first resolution is smaller than the second resolution.

As an example, the processing chip 20 may combine all the pixels of each sub-unit of the panchromatic original image as the panchromatic large pixel W corresponding to the sub-unit in a way as follows. The processing chip 20 first combines the pixel values of all pixels in each sub-unit of the panchromatic original image to obtain the pixel value of the panchromatic large pixel W corresponding to the sub-unit, and then forms the panchromatic intermediate image according to the pixel values of the multiple panchromatic large pixels W. Specifically, for each panchromatic large pixel, the processing chip 20 may add all the pixel values in the sub-unit including the null pixels N and the panchromatic pixels W, and use the result of the addition as the pixel value of the panchromatic large pixel W corresponding to the sub-unit, where the pixel value of the null pixel N can be regarded as zero. In this way, the processing chip 20 can obtain the pixel values of the multiple panchromatic large pixels W.

After the processing chip 20 obtains the panchromatic intermediate image and the color intermediate image, it can perform fusion processing on the panchromatic intermediate image and the color intermediate image to obtain the second target image.

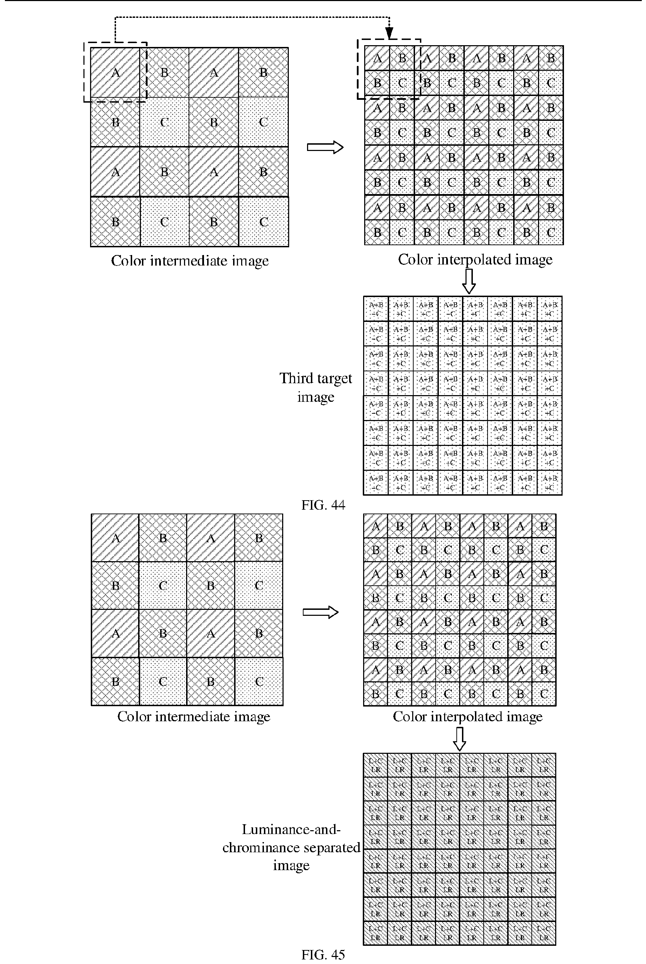

For example, as shown in FIG. 43, the processing chip 20 first separates the luminance and chrominance of the color intermediate image to obtain a luminance-and-chrominance separated image. As shown in FIG. 43, in the luminance-and-chrominance separated image, L represents luminance, and CLR represents chrominance. Specifically, it is assumed that the monochromatic pixel A is the red pixel R, the monochromatic pixel B is the green pixel G, and the monochromatic pixel C is the blue pixel Bu. In this case, (1) the processing chip 20 can convert the color intermediate image in RGB space into a luminance-and-chrominance separated image in YCrCb space, at this time, Y in YCrCb represents the luminance L in the luminance-and-chrominance separated image, and Cr and Cb in YCrCb represent the chrominance CLR in the luminance-and-chrominance separated image. (2) The processing chip 20 can also convert the color intermediate image in RGB space into a luminance-and-chrominance separated image in Lab space, at this time, L in Lab represents the luminance L in the luminance-and-chrominance separated image, and a and b in Lab represent the chrominance CLR in the luminance-and-chrominance separated image. It should be noted that L+CLR in the luminance-and-chrominance separated image shown in FIG. 44 does not mean that the pixel value of each pixel is formed by adding L and CLR, but only means that the pixel value of each pixel is composed of L and CLR.

Subsequently, the processing chip 20 fuses the luminance of the luminance-and-chrominance separated image and the luminance of the panchromatic intermediate image. For example, the pixel value of each panchromatic large pixel W in the panchromatic intermediate image is the luminance of the panchromatic large pixel, and the processing chip 20 may add the value of L of each pixel in the luminance-and-chrominance separated image with the value of the panchromatic large pixel W at a corresponding position in the panchromatic intermediate image, to obtain the luminance-corrected pixel value. The processing chip 20 forms a luminance-corrected luminance-and-chrominance separated image according to multiple luminance-corrected pixel values, and then uses color space conversion to convert the luminance-corrected luminance-and-chrominance separated image into the luminance-corrected color image.

When the monochromatic large pixel A is the red pixel R, the monochromatic large pixel B is the green pixel G, and the monochromatic large pixel C is the blue pixel Bu, the luminance-corrected color image is in Bayer array arrangement, and the processing chip 20 needs to perform value-interpolation processing on the luminance-corrected color image, so that the pixel value of each monochromatic large pixel after the luminance correction has three components of R, G, and B at the same time. The processing chip 20 may perform the value-interpolation processing on the luminance-corrected color image to obtain the second target image. For example, linear interpolation may be adopted to obtain the second target image. The process of the linear interpolation is similar to those mentioned in the foregoing block 040, which will not be repeated here.

Since the luminance-corrected color image has the first resolution, the second target image is obtained by performing the value-interpolation processing on the luminance-corrected color image, and the processing chip 20 does not perform pixel-interpolation processing on the luminance-corrected color image, therefore, the second target image also has the first resolution. Since the second target image is obtained by fusing the luminance of the color intermediate image and the luminance of the panchromatic intermediate image, the second target image has a better imaging effect. When it is in both the preview mode and the non-low power consumption mode, the second target image may be adopted as the preview image, which can improve the preview effect of the preview image. When it is in both the imaging mode and the low power consumption mode, the second target image may be adopted as the image provided to the user. Since the second target image is calculated without the pixel-interpolation processing, the power consumption of the camera assembly 40 can be reduced at a certain extent, meeting the usage requirements in the low power consumption mode. In addition, the second target image has relatively high luminance, which can meet the user's luminance requirements for the target image.

Referring to FIG. 41 again, in another example, when the target image is the third target image, block 04 includes operation as follows:
At block 044, pixel-interpolation processing is performed on the color intermediate image to obtain a color interpolated image with the second resolution, where the corresponding sub-units in the color interpolated image are in Bayer array arrangement, and the second resolution is greater than the first resolution.

At block 045, value-interpolation processing is performed on each of the monochromatic pixels in the color interpolated image to obtain and output pixel values of the other two colors than its own single color, so as to obtain a third target image with the second resolution.

Referring to FIG. 33, both the blocks 044 and 045 can be implemented by the processing chip 20. In other words, the processing chip 20 can be configured to perform pixel-interpolation processing on the color intermediate image to obtain a color interpolated image with the second resolution. The corresponding sub-units in the color interpolated image are in Bayer array arrangement, and the second resolution is greater than the first resolution. The processing chip 20 can also be configured to perform value-interpolation processing on each of the monochromatic pixels in the color interpolated image to obtain and output pixel values of the other two colors other than its own single color, so as to obtain the third target image with the second resolution.

Specifically, referring to Fig. 44, the processing chip 20 splits each monochromatic large pixel in the color intermediate image into four monochromatic pixels. The four monochromatic pixels form a sub-unit in the color interpolated image, and each sub-unit includes monochromatic pixels of three colors, including one monochromatic pixel A, two monochromatic pixels B, and one monochromatic pixel C. When the monochromatic pixel A is the red pixel R, the monochromatic pixel B is the green pixel G, and the monochromatic pixel C is the blue pixel Bu, the multiple monochromatic pixels in each sub-unit are in Bayer array arrangement. Thus, the color interpolated image including the multiple sub-units is in Bayer array arrangement. The processing chip 20 may perform value-interpolation processing on the color interpolated image to obtain the third target image. For example, the linear interpolation may be adopted to obtain the second target image. The process of the linear interpolation is similar to those mentioned in the foregoing block 040, which will not be repeated here. The third target image is obtained through the pixel-interpolation processing, and thus the resolution (i.e., the second resolution) of the third target image is greater than the resolution (i.e., the first resolution) of the color intermediate image. When it is in both the preview mode and the non-low power consumption mode, the third target image may be adopted as the preview image to provide a clearer preview image. When it is in both the imaging mode and the low power consumption mode, the third target image may also be adopted as the image provided to the user. Since no luminance fusion needs to be performed with the panchromatic intermediate image during the formation of the third target image, the power consumption of the camera assembly 40 can be reduced at a certain extent; in addition, the user's requirements for the clarity of the captured image can be met.

Referring to FIG. 41 again, in another example, when the target image is the fourth target image, block 03 includes an operation as follows:
At block 032, pixel-interpolation processing is performed on the panchromatic original image, and the pixel values of all pixels in each sub-unit are acquired to obtain the panchromatic intermediate image with the second resolution.

In addition, block 04 includes operation as follows:
At block 046, pixel-interpolation processing is performed on the color intermediate image to obtain the color interpolated image with the second resolution, where the corresponding sub-units in the color interpolated image are in Bayer array arrangement, and the second resolution is greater than the first resolution.

At block 047, luminance and chrominance of the color interpolated image are separated to obtain a luminance-and-chrominance separated image with the second resolution.

At block 048, the luminance of the panchromatic intermediate image and the luminance of the luminance-and-chrominance separated image are fused to obtain a luminance-corrected color image with the second resolution.

At block 049, value-interpolation processing is performed on each of the monochromatic pixels in the luminance-corrected color image to obtain and output the pixel values of the other two colors than its own single color, so as to obtain the fourth target image with the second resolution.

Referring to FIG. 33, blocks 032, 046, 047, 048 and 049 can all be implemented by the processing chip 20. In other words, the processing chip 20 can be configured to perform the pixel-interpolation processing on the panchromatic original image, and acquire the pixel values of all pixels in each sub-unit, to obtain the panchromatic intermediate image with the second resolution. The processing chip 20 can also be configured to perform the pixel-interpolation processing on the color intermediate image to obtain a color interpolated image with the second resolution, where the corresponding sub-units in the color interpolated image are in Bayer array arrangement, and the second resolution is greater than the first resolution. The processing chip 20 can also be configured to separate the luminance and chrominance of the color interpolated image to obtain a luminance-and-chrominance separated image with the second resolution, fuse the luminance of the panchromatic interpolated image and the luminance of the luminance-and-chrominance separated image to obtain a luminance-corrected color image with the second resolution, and perform the value-interpolation processing on each of the monochromatic pixels in the luminance-corrected color image to obtain and output the pixel values of the other two colors than its own single color, so as to obtain the fourth target image with the second resolution.

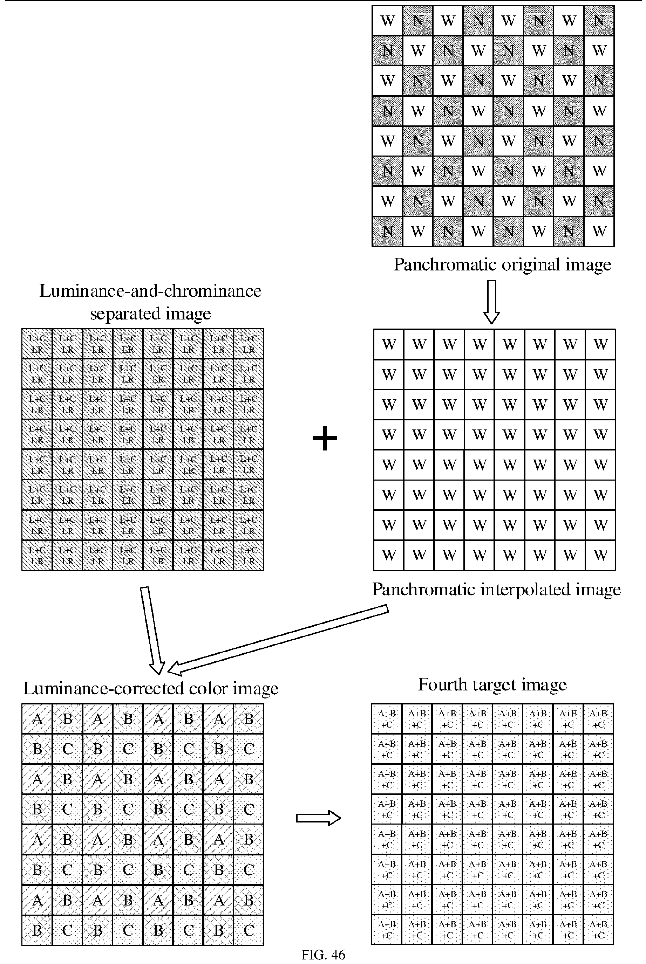

Specifically, the processing chip 20 first performs pixel-interpolation processing on the panchromatic original image with the first resolution to obtain the panchromatic intermediate image with the second resolution. Referring to FIG. 46, the panchromatic original image includes multiple sub-units, and each sub-unit includes two null pixels N and two panchromatic pixels W. The processing chip 20 needs to replace each null pixel N in each sub-unit with a panchromatic pixel W, and calculate the pixel value of each panchromatic pixel W which replaces the respective null pixel N. For each null pixel N, the processing chip 20 replaces the null pixel N with a panchromatic pixel W, and determines the pixel value of the replacement panchromatic pixel W according to the pixel values of other panchromatic pixels W adjacent to the replacement panchromatic pixel W. Taking the null pixel N_{1,8} in the panchromatic original image shown in FIG. 46 ("null pixel N_{1,8}" is the null pixel N in the first row and eighth column counting from the upper left corner, which is true for the following) as an example, the null pixel N_{1,8} is replaced by a panchromatic pixel W_{1,8}, and the pixels adjacent to the panchromatic pixel W_{1,8} are the panchromatic pixel W_{1,7} and the panchromatic pixel W_{2,8} in the panchromatic original image. As an example, an average value of the pixel value of the panchromatic pixel W_{1,7} and the pixel value of the panchromatic pixel W_{2,8} is taken as the pixel value of the panchromatic pixel W_{1,8}. Taking the null pixel N_{2,3} in the panchromatic original image shown in FIG. 46 as an example, the null pixel N_{2,3} is replaced by a panchromatic pixel W_{2,3}, and the panchromatic pixels adjacent to the panchromatic pixel W_{2,3} are the panchromatic pixel W_{1,3}, the panchromatic pixel W_{2,2}, the panchromatic pixel W_{2,4}, and the panchromatic pixel W_{3,3} in the panchromatic original image. As an example, the processing chip 20 sets an average value of the pixel value of the panchromatic pixel W₃, the pixel value of the panchromatic pixel W_{2,2}, the pixel value of the panchromatic pixel W_{2,4}, and the pixel value of the panchromatic pixel W_{3,3} as the pixel value of the replacement panchromatic pixel W_{2,3}.

After the processing chip 20 obtains the panchromatic intermediate image and the color intermediate image, it can perform fusion processing on the panchromatic intermediate image and the color intermediate image to obtain the fourth target image.

First, the processing chip 20 may perform pixel-interpolation processing on the color intermediate image with the first resolution to obtain the color interpolated image with the second resolution, as shown in FIG. 45. The specific pixel-interpolation method is similar to those mentioned in block 045, which will not be repeated here.

Subsequently, as shown in FIG. 45, the processing chip 20 can separate the luminance and chrominance of the color interpolated image to obtain a luminance-and-chrominance separated image. In the luminance-and-chrominance separated image in FIG. 45, L represents luminance, and CLR represents chrominance. Specifically, it is assumed that the monochromatic pixel A is the red pixel R, the monochromatic pixel B is the green pixel G, and the monochromatic pixel C is the blue pixel Bu. In this case, (1) the processing chip 20 can convert the color interpolated image in RGB space into a luminance-and-chrominance separated image in YCrCb space, at this time, Y in YCrCb represents the luminance L in the luminance-and-chrominance separated image, and Cr and Cb in YCrCb represent the chrominance CLR in the luminance-and-chrominance separated image. (2) The processing chip 20 can also convert the color interpolated image in RGB space into a luminance-and-chrominance separated image in Lab space, at this time, L in Lab represents the luminance L in the luminance-and-chrominance separated image, and a and b in Lab represent the chrominance CLR in the luminance-and-chrominance separated image. It should be noted that L+CLR in the luminance-and-chrominance separated image shown in FIG. 45 does not mean that the pixel value of each pixel is formed by adding L and CLR, but only means that the pixel value of each pixel is composed of L and CLR.

Subsequently, as shown in FIG. 46, the processing chip 20 may fuse the luminance of the luminance-and-chrominance separated image and the luminance of the panchromatic intermediate image. For example, the pixel value of each panchromatic pixel W in the panchromatic intermediate image is the luminance of the panchromatic pixel, and the processing chip 20 may add the value of L of each pixel in the luminance-and-chrominance separated image with the value of the panchromatic pixel W at a corresponding position in the panchromatic intermediate image, to obtain the luminance-corrected pixel value. The processing chip 20 forms a luminance-corrected luminance-and-chrominance separated image according to multiple luminance-corrected pixel values, and then converts the luminance-corrected luminance-and-chrominance separated image into the luminance-corrected color image. The luminance-corrected color image has the second resolution.

When the monochromatic pixel A is the red pixel R, the monochromatic pixel B is the green pixel G, and the monochromatic pixel C is the blue pixel Bu, the luminance-corrected color image is in Bayer array arrangement, and the processing chip 20 needs to perform value-interpolation processing on the luminance-corrected color image, so that the pixel value of each monochromatic pixel after the luminance correction has three components of R, G, and B at the same time. The processing chip 20 may perform the value-interpolation processing on the luminance-corrected color image to obtain the fourth target image. For example, linear interpolation may be adopted to obtain the fourth target image. The process of the linear interpolation is similar to those mentioned in the foregoing block 040, which will not be repeated here.

Since the fourth target image is obtained by fusing the luminance of the color intermediate image and the luminance of the panchromatic intermediate image, and the fourth target image has a large resolution, the fourth target image has better luminance and clarity. When it is in both the imaging mode and the non-low power consumption mode, the fourth target image may be adopted as the image provided to the user, which can meet the user's quality requirements for the captured image.

In some embodiments, in the image capturing method, the ambient brightness may also be acquired. This operation can be implemented by the processing chip 20, and the specific implementation thereof may refer to the foregoing description, which will not be repeated here. When the ambient brightness is greater than the brightness threshold, the first target image or the third target image may be adopted as the target image. When the ambient brightness is less than or equal to the brightness threshold, the second target image or the fourth target image may be adopted as the target image. It can be understood that, when the ambient brightness is relatively high, the luminance of each of the first target image and the second target image that are obtained only from the color intermediate image is sufficient to meet the user's brightness requirements for the target image, and there is no need to fuse the luminance of the panchromatic intermediate image to increase the luminance of the target image. In this way, not only can the amount of calculation of the processing chip 20 be reduced, but also the power consumption of the camera assembly 40 can be reduced. When the ambient brightness is low, the luminance of each of the first target image and the second target image that are obtained only from the color intermediate image may be insufficient to meet the user's brightness requirements for the target image, and the second target image or the fourth target image, which are obtained by fusing the luminance of the panchromatic intermediate image, may be adopted as the target image, which can increase the luminance of the target image.

Referring to FIG. 47, the embodiments of the disclosure also provide a mobile terminal 60. The mobile terminal 60 can be a mobile phone, a tablet computer, a notebook computer, a smart wearable device (such as a smart watch, a smart bracelet, a smart glasses, or a smart helmet), a head-mounted display device, a virtual reality device, or the like, which are not limited here.

The mobile terminal 60 includes a housing 50 and the camera assembly 40. The housing 50 is joined with the camera assembly 40. For example, the camera assembly 40 may be installed on the housing 50. The mobile terminal 60 may also include a processor (not shown). The processing chip 20 in the camera assembly 40 and the processor may be the same processor or two independent processors, which is not limited here.

In the description of this specification, the description with reference to the terms such as "one embodiment", "some embodiments", "exemplary embodiments", "examples", "specific examples" or "some examples" mean that the specific features, structures, materials, or characteristics described in connection with the related embodiment or example are included in at least one embodiment or example of the present disclosure. In this specification, the exemplary expressions of the above terms do not necessarily involve the same embodiment or example. In addition, the described specific features, structures, materials, or characteristics may be combined with one or more other embodiments or examples in an appropriate manner. In addition, those skilled in the art can combine the different embodiments or examples and combine the features of the different embodiments or examples described in this specification without contradicting each other.

Any process or method described in the flowchart or in other ways herein can be understood as a module, segment or part of codes of one or more executable instructions for implementing specific logical functions or steps of the process. And the scope of the preferred embodiments of the present disclosure includes additional implementations. The implementations of the functions may not be in the order shown or discussed, in which the functions may be implemented in a substantially simultaneous manner or in the reverse order according to the functions involved, this should be understood by those skilled in the art to which the embodiments of this disclosure belong.

Although the embodiments of this disclosure have been shown and described above, it can be understood that the above embodiments are exemplary and should not be construed as limitations on this disclosure. Those of ordinary skill in the art can make changes, modifications, replacements and variations to these embodiments within the scope of this disclosure.

## Claims

1. An image sensor, comprising a plurality of pixels, wherein each of the plurality of pixels comprises:
an isolation layer;
a light guide layer formed in the isolation layer, a refractive index of the light guide layer being greater than a refractive index of the isolation layer; and
a photoelectric conversion element configured to receive light passing through the light guide layer.

2. The image sensor as claimed in claim 1, wherein the refractive index of the light guide layer is constant along a light-receiving direction of the image sensor.

3. The image sensor as claimed in claim 1, wherein the refractive index of the light guide layer gradually increases along a light-receiving direction of the image sensor.

4. The image sensor as claimed in claim 1, wherein the image sensor further comprises an optical isolation interlayer arranged between the isolation layers of two adjacent pixels.

5. The image sensor as claimed in claim 1, wherein the plurality of pixels comprises a plurality of panchromatic pixels and a plurality of monochromatic pixels;
the monochromatic pixels have a narrower spectral response range than the panchromatic pixels, and each of the panchromatic pixels has a larger full well capacity than each of the monochromatic pixels.

6. The image sensor as claimed in claim 5, wherein each of the plurality of pixels comprises the photoelectric conversion element, and each of the photoelectric conversion elements comprises a substrate and an n-well layer formed in the substrate.

7. The image sensor as claimed in claim 6, wherein a size of a cross section of the n-well layer of each of the panchromatic pixels is equal to a size of a cross section of the n-well layer of each of the monochromatic pixels, and a depth of the n-well layer of each of the panchromatic pixels is greater than a depth of the n-well layer of each of the monochromatic pixels.

8. The image sensor as claimed in claim 6, wherein a size of a cross section of the n-well layer of each of the panchromatic pixels is larger than a size of a cross section of the n-well layer of each of the monochromatic pixels, and a depth of the n-well layer of each of the panchromatic pixels is greater than a depth of the n-well layer of each of the monochromatic pixels.

9. The image sensor as claimed in claim 6, wherein a size of a cross section of the n-well layer of each of the panchromatic pixels is larger than a size of a cross section of the n-well layer of each of the monochromatic pixels, and a depth of the n-well layer of each of the panchromatic pixels is equal to a depth of the n-well layer of each of the monochromatic pixels.

10. The image sensor as claimed in claim 8 or 9, wherein along the light-receiving direction of the image sensor, the sizes of the individual cross sections of the n-well layer of each of the plurality of pixels are equal.

11. The image sensor as claimed in claim 6, wherein sizes of individual cross sections of the n-well layer of each of the panchromatic pixels gradually increase along a light-receiving direction of the image sensor, sizes of individual cross sections of the n-well layer of each of the monochromatic pixels gradually decrease along the light-receiving direction, and the size of a smallest one of the cross sections of the n-well layer of each of the panchromatic pixels is greater than or equal to the size of a largest one of the cross sections of the n-well layer of each of the monochromatic pixels.

12. The image sensor as claimed in any one of claims 6 to 11, wherein a depth of the photoelectric conversion element of each of the panchromatic pixels is equal to a depth of the photoelectric conversion element of each of the monochromatic pixels.

13. The image sensor as claimed in any one of claims 6 to 11, wherein each of the plurality of pixels comprises a microlens and an optical filter, and the microlens, the optical filter, the isolation layer, and the photoelectric conversion element are arranged in sequence along a light-receiving direction of the image sensor.

14. The image sensor as claimed in claim 13, wherein along the light-receiving direction of the image sensor, sizes of individual cross sections of the isolation layer of each of the plurality of pixels are equal.

15. The image sensor as claimed in claim 13, wherein when a size of a cross section of the n-well layer of each of the panchromatic pixels is larger than a size of a cross section of the n-well layer of each of the monochromatic pixels, and when the sizes of the individual cross sections of the n-well layer of each of the plurality of pixels are equal along the light-receiving direction, sizes of individual cross sections of the isolation layer of each of the panchromatic pixels gradually increase along the light-receiving direction, and sizes of individual cross sections of the isolation layer of each of the monochromatic pixels gradually decrease along the light-receiving direction.

16. The image sensor as claimed in claim 13, wherein when sizes of individual cross sections of the n-well layer of each of the panchromatic pixels gradually increase along the light-receiving direction of the image sensor, and when sizes of individual cross sections of the n-well layer of each of the monochromatic pixels gradually decrease along the light-receiving direction, sizes of individual cross sections of the isolation layer of each of the panchromatic pixels gradually increase along the light-receiving direction, and sizes of individual cross sections of the isolation layer of each of the monochromatic pixels gradually decrease along the light-receiving direction.

17. The image sensor as claimed in any one of claims 14 to 16, wherein along the light-receiving direction, sizes of individual cross sections of the light guide layer of each of the plurality of pixels are equal.

18. The image sensor as claimed in any one of claims 14 to 16, wherein sizes of individual cross sections of the light guide layer of each of the plurality of pixels gradually decrease along the light-receiving direction.

19. A camera assembly, comprising:
a lens; and
an image sensor as claimed in any one of claims 1 to 18, the image sensor being configured to receive light passing through the lens to obtain an original image.

20. A mobile terminal, comprising:
a housing; and
a camera assembly as claimed in claim 19, the camera assembly being jointed with the housing.
